# EUROPÄISCHE PATENTANMELDUNG

(11) **EP 4 836 664 A1**
(43) Veröffentlichungstag der Anmeldung: **04.11.2026**
(21) Anmeldenummer: 26175323.0
(22) Anmeldetag: 29.04.2026
(51) Int. Cl.: H10N 30/87, G01N 29/02, H03H 9/05

(54) **PIEZOELEKTRISCHER RESONATOR, VERWENDUNGSVERFAHREN UND MULTIVARIABLER SENSOR**

(30) Priorität: 30.04.2025 DE 102025116829
(71) Anmelder: WIKA Alexander Wiegand SE & Co. KG, 63911 Klingenberg/Main (DE)
(72) Erfinder: PFEIFER, Fabian, 63820 Elsenfeld (DE)
(74) Vertreter: Benninger, Johannes

(57) **Zusammenfassung**

Die Erfindung betrifft einen piezoelektrischen Resonator (1000) mit einem piezoelektrischen Substrat (1100) mit einem Basisabschnitt (1110) und einem Anregungsabschnitt (1120) sowie einer Elektrodenstruktur (1200), welche zumindest abschnittsweise am oder im Anregungsabschnitt (1120) angeordnet ist. Die Elektrodenstruktur (1200) umfasst weiterhin eine erste multifunktionale Elektrode (1210), welche einen ersten Hauptkontakt (1211) und einen ersten Nebenkontakt (1212) aufweist. Weiterhin umfasst die Erfindung einen Multivariablensensor (4000) mit einem piezoelektrischen Resonator (1000), sowie ein Verfahren zur Verwendung eines piezoelektrischen Resonators (1000).

## Beschreibung

Die vorliegende Erfindung betrifft einen piezoelektrischen Resonator, ein Verwendungsverfahren für einen solchen piezoelektrischen Resonator sowie einen Multivariablensensor mit einem solchen piezoelektrischen Resonator.

Piezoelektrische Resonatoren sind wesentliche Komponenten in einer Vielzahl von elektronischen Geräten, insbesondere in Oszillatoren und Filtern. Diese Resonatoren nutzen die piezoelektrischen Eigenschaften bestimmter Materialien, um mechanische Schwingungen in elektrische Signale umzuwandeln und umgekehrt.

In der Vergangenheit wurden piezoelektrische Resonatoren hauptsächlich in Form von Kristallresonatoren und Keramikresonatoren entwickelt. Diese Resonatoren zeichnen sich durch ihre hohe Stabilität und Präzision aus, was sie ideal für Anwendungen in der Kommunikation, der Automobilindustrie, der Medizintechnik und der Messtechnik macht.

Ein bedeutendes Gebiet der Entwicklung ist die Integration von piezoelektrischen Resonatoren in Mikroelektromechanische Systeme (im Folgenden abgekürzt als MEMS). MEMS-Resonatoren bieten den Vorteil einer miniaturisierten Bauweise und können in einer Vielzahl von Anwendungen eingesetzt werden, beispielsweise in der Sensorik. Die Herstellung und Qualifizierung dieser Resonatoren erfordert fortschrittliche Herstellungstechniken und Testverfahren, um ihre Leistungsfähigkeit und Zuverlässigkeit sicherzustellen.

In der Sensorik finden piezoelektrische Resonatoren insbesondere eine breite Anwendung für die Messung von Dichte und Viskosität in flüssigen Medien. Diese Sensoren sind in der Lage, präzise Messungen durchzuführen, indem sie den Resonator zunächst zu mechanischen Schwingungen anregen, um anschließend das Schwingverhalten und insbesondere der Abklingverhalten dieser Schwingung zu analysieren. Daraus können Änderungen in der Dichte und/oder Viskosität des umgebenden Mediums präzise detektiert werden. Solche Sensoren werden häufig in industriellen Anwendungen eingesetzt, beispielsweise zur Überwachung der Ölqualität in Maschinen und mobilen Arbeitsmaschinen. Durch die kontinuierliche Überwachung der Dichte und Viskosität von Ölen können Wartungsintervalle optimiert und Ausfallzeiten reduziert werden.

Trotz der Fortschritte in der Technologie gibt es weiterhin Herausforderungen bei der Optimierung der Funktionalität und Vielseitigkeit von piezoelektrischen Resonatoren.

Ein erster Aspekt der vorliegenden Erfindung zielt darauf ab, diese Herausforderungen zu adressieren, indem ein piezoelektrischer Resonator mit einer innovativen Elektrodenstruktur bereitgestellt wird. Ein zweiter Aspekt der Erfindung betrifft ein Verfahren zur Verwendung eines piezoelektrischen Resonators. Ein dritter Aspekt der Erfindung betrifft die Verwendung eines piezoelektrischen Resonators in einem Multivariablensensor. Vorteilhafte Ausgestaltungen und Weiterbildungen der verschiedenen Aspekte der Erfindung sind jeweils Gegenstand der abhängigen Ansprüche.

Gemäß dem ersten Aspekt der Erfindung umfasst ein piezoelektrischer Resonator ein piezoelektrisches Substrat mit einem Basisabschnitt und einem Anregungsabschnitt und einer Elektrodenstruktur, welche zumindest abschnittsweise am oder im Anregungsabschnitt angeordnet ist.

Als Substrat wird dabei ein Körper aus einem piezoelektrischen Material bezeichnet, dessen Ausdehnung in einer Raumrichtung - welche im Folgenden als Höhe oder Dicke des Substrats bezeichnet wird - geringer ist, als seine Ausdehnung in den beiden dazu senkrechten Raumrichtungen - welche im Folgenden als Länge und Breite des Substrats bezeichnet werden. Wenn im Folgenden von der Länge des piezoelektrischen Substrats gesprochen wird, so ist damit jene räumliche Ausdehnungsrichtung des Substrats gemeint, welche im Wesentlichen einer Ausdehnung des Substrats vom Basisabschnitt hin zum Anregungsabschnitt entspricht. Die Dicke des Substrats kann in exemplarischen Ausgestaltungen zwischen 100 und 350 Mikrometern liegen, während die Breite zwischen 300 und 750 Mikrometern und die Länge zwischen 2500 und 10000 Mikrometern liegen kann. Durch entsprechende Maße kann eine hohe Stabilität mit guten Schwingungseigenschaften vereint werden.

Als Elektrodenstruktur wird im Sinne dieser Schrift die Gesamtheit aller Leiterbahnen, Elektroden, Kontakte und sonstiger elektronischer Strukturen bezeichnet, welche gegebenenfalls von einer jeweiligen Ausgestaltung des piezoelektrischen Resonators umfasst sind.

Der Basisabschnitt ist dazu eingerichtet, mit weiteren Komponenten verbunden zu werden, beispielsweise mit einem Träger oder einem Gehäuse einer übergeordneten Einheit, wie etwa einem im weiteren Verlauf noch näher beschriebenen Multivariablensensor. Weiterhin können elektrische Kontakte, insbesondere Kontaktpads, der Elektrodenstruktur an einem vom Anregungsabschnitt abgewandten Rand des Basisabschnitts angeordnet sein, sodass diese für eine einfache und zuverlässige Kontaktierung räumlich konzentriert zur Verfügung stehen.

"Zumindest abschnittsweise" bedeutet im Kontext der Anordnung der Elektrodenstruktur relativ zum Anregungsabschnitt, dass die Ausdehnung der Elektrodenstruktur in Richtung der Länge des piezoelektrischen Substrats derart mit diesem überlappt, dass es eine nicht-verschwindende Schnittfläche zwischen der Elektrodenstruktur und dem Anregungsabschnitt gibt. Dadurch wird ermöglicht, dass der Anregungsabschnitt des piezoelektrischen Substrats wirksam durch Teile - insbesondere Elektroden - der Elektrodenstruktur zu mechanischen Schwingungen angeregt werden kann. Vorzugsweise überlappt sich die Elektrodenstruktur dabei zumindest mit 25 Prozent der Länge, bevorzugt mit mindestens 50 Prozent der Länge, besonders bevorzugt im Wesentlichen mit der gesamten Länge des Anregungsabschnitts.

Dass die Elektrodenstruktur "am oder im" Anregungsabschnitt (zumindest abschnittsweise) angeordnet ist, drückt aus, dass vielfältige Techniken verwendet werden können, um die Elektrodenstruktur mit dem piezoelektrischen Substrat zu verbinden bzw. in dieses zu integrieren. Wenn die Elektrodenstruktur "am" Anregungsabschnitt (zumindest abschnittsweise) angeordnet ist, bedeutet das, dass diese auf einer Oberfläche des piezoelektrischen Substrats aufgetragen ist. Für eine derartige Anordnung kommen beispielsweise Verfahren wie die physikalische Gasphasenabscheidung (PVD) aus der Gruppe der Dünnfilm-Technologien in Frage. Eine (zumindest abschnittsweise) Anordnung "im" piezoelektrischen Substrat kann hingegen bedeuten, dass die Elektrodenstruktur im Körper des Substrats - also bspw. durch Einsenkung der Elektrodenstruktur in die Oberfläche des Substratkörpers hinein - eingebettet ist. Dazu kommen beispielsweise Dotierungsverfahren in Frage. Ebenso wird im Sinne dieser Erfindung auch eine Anordnung einer Elektrodenstruktur zwischen zwei zusammengefügten Teilschichten eines aus mehreren Schichten aufgebauten Substrats als Anordnung "im" Substrat verstanden.

Erfindungsgemäß umfasst die Elektrodenstruktur des piezoelektrischen Resonators eine erste multifunktionale Elektrode.

Während herkömmliche Elektroden, wie sie im Stand der Technik zum elektrischen Ladungstransport zwischen den Anregungsabschnitten und einer Steuerelektronik verwendet werden, nur einen einzigen Kontakt - im Folgenden deshalb auch als "Einzelkontakt" bezeichnet - aufweisen, weist die erste multifunktionale Elektrode einen ersten Hauptkontakt und einen ersten Nebenkontakt auf. Der erste Hauptkontakt und der erste Nebenkontakt können dabei grundsätzlich gleich ausgebildet sein, sind jedoch nicht direkt miteinander kurzgeschlossen, sondern elektrisch durch die multifunktionale Elektrode voneinander getrennt beziehungsweise nur durch die multifunktionale Elektrode miteinander resistiv, induktiv oder kapazitiv gekoppelt.

Anders ausgedrückt, wird es durch den ersten Hauptkontakt und den ersten Nebenkontakt möglich, verschiedene elektronische Mess- und/oder Betriebsfunktionen mit der multifunktionalen Elektrode auszuführen, die über ein einfaches Anlegen eines Potenzials oder eines Anregungssignals - wie es im Stand der Technik mit herkömmlichen Elektroden ausgeübt wird - weit hinausgehen. Beispielsweise wird es somit möglich, zwischen dem ersten Hauptkontakt und dem ersten Nebenkontakt eine Spannungsmessung und/oder eine Widerstandsmessung und/oder eine Kapazitätsmessung an der ersten multifunktionalen Elektrode auszuführen. Ebenso kann beispielsweise zwischen dem ersten Hauptkontakt und dem ersten Nebenkontakt ein Heizstrom oder ein Prüfstrom durch die erste multifunktionale Elektrode geleitet werden. Je nach konkreter Ausgestaltung der ersten multifunktionalen Elektrode kann somit, wie in folgenden Beispielen noch näher erläutert wird, eine Vielzahl von zusätzlichen Messaufgaben oder Betriebsfunktionen umgesetzt werden, sodass der piezoelektrische Resonator vielfältig und multifunktional eingesetzt werden kann und zugleich ein hoher Grad an Integration und Miniaturisierung erzielbar ist.

Wenn hierin und im Folgenden bestimmte Elemente, Baugruppen oder funktionale Einheiten jeweils als "erste" bezeichnet werden, erfolgt dies lediglich zu dem Zweck einer eindeutigen Benennung. Das heißt, diese Bezeichnung ist in keiner Weise einschränkend zu verstehen. Ebenso impliziert diese Bezeichnung nicht das Vorhandensein oder Nicht-Vorhandensein weiterer Elemente, Baugruppen oder funktionalen Einheiten der gleichen Art. So wird durch die Benennung "erste funktionale Elektrode" weder impliziert noch ausgeschlossen, dass auch eine "zweite funktionale Elektrode" vorhanden sein muss oder kann. Gleichzeitig ist dadurch, dass die erste multifunktionale Elektrode den "ersten Hauptkontakt" und den "ersten Nebenkontakt" umfasst, weder impliziert noch ausgeschlossen, dass sie auch noch weitere Kontakte aufweist.

In einer exemplarischen Ausgestaltung des ersten Aspekts der Erfindung umfasst die Elektrodenstruktur eine erste einzelfunktionale Elektrode mit einem ersten Einzelkontakt und eine zweite einzelfunktionale Elektrode mit einem zweiten Einzelkontakt.

Wenn im Folgenden von einem/einer "zweiten" Element, Baugruppe oder funktionalen Einheit gesprochen wird, erfolgen auch diese Bezeichnungen lediglich zu dem Zweck einer eindeutigen Benennung. Das heißt, diese Bezeichnungen sind ebenfalls in keiner Weise einschränkend zu verstehen. Ebenso impliziert keine dieser Bezeichnungen das Vorhandensein oder Nicht-Vorhandensein weiterer Elemente, Baugruppen oder funktionalen Einheiten der gleichen Art. So wird durch eine noch folgende Benennung einer "zweiten einzelfunktionalen Elektrode" weder impliziert noch ausgeschlossen, dass noch weitere funktionale Elektroden vorhanden sein müssen oder können.

Die erste einzelfunktionale Elektrode und die zweite einzelfunktionale Elektrode können beispielsweise herkömmlichen Elektroden, wie sie im Stand der Technik zur Anregung von piezoelektrischen Resonatoren verwendet werden, entsprechen. Sie weisen nur einen einzigen Kontakt auf, welcher ausreichend dafür ist, ein Potenzial oder Anregungssignal anzulegen. Um deutlich auszudrücken, dass sie nur einen einzigen Kontakt aufweisen, wird dieser jeweils als "Einzelkontakt" bezeichnet. In Abgrenzung zur ersten multifunktionalen Elektrode werden diese herkömmlichen Elektroden zudem als "einzelfunktional" bezeichnet, um zu verdeutlichen, dass diese nicht dazu geeignet oder ausgebildet sind, um bestimmte elektronische Mess- und/oder Betriebsfunktionen auszuführen, die über das genannte, einfache Anlegen eines Potenzials oder eines Anregungssignals hinausgehen.

Die erste einzelfunktionale Elektrode und die zweite einzelfunktionale Elektrode sind jeweils zumindest abschnittsweise am oder im Anregungsabschnitt angeordnet, während die erste multifunktionale Elektrode in dieser Ausgestaltung an einer beliebigen Stelle am piezoelektrischen Substrat angeordnet ist, also etwa vollständig am oder im Basisabschnitt oder auch zumindest abschnittsweise am oder im Anregungsabschnitt. Die Formulierungen "zumindest abschnittsweise" und "am oder im" drücken hierbei jeweils analog aus, was im Vorangegangenen bereits zu entsprechenden Formulierungen im Kontext der Anordnung der Elektrodenstruktur relativ zum Anregungsabschnitt erläutert wurde.

Dadurch, dass in dieser Ausgestaltung zwei einzelfunktionale Elektroden - nämlich die erste einzelfunktionale Elektrode und die zweite einzelfunktionale Elektrode - vorhanden und zumindest abschnittsweise am oder im Anregungsabschnitt angeordnet sind, kann der Anregungsabschnitt des piezoelektrischen Substrats schon dadurch zu mechanischen Schwingungen angeregt werden, dass jeweils an den ersten Einzelkontakt und den zweiten Einzelkontakt ein Anregungssignal angelegt wird. Falls es die Geometrie des Substrats, gegebenenfalls in Verbindung mit Materialeigenschaften des gewählten piezoelektrischen Materials des Substrats, oder eine Anforderung an die Art oder Qualität der Schwingungen erfordert, ist es in dieser Ausgestaltung jedoch nicht ausgeschlossen, dass die Elektrodenstruktur auch noch weitere einzelfunktionale Elektroden umfasst, welche ebenfalls an der Schwingungsanregung mitwirken können.

Die erste multifunktionale Elektrode wirkt jedoch in dieser Ausgestaltung nicht an der Anregung von Schwingungen im Bereich des Anregungsabschnitts mit und kann daher jederzeit zwecks Ausführung verschiedener Mess- oder Betriebsfunktionen über den ersten Hauptkontakt und den ersten Nebenkontakt kontaktiert werden. Daher spielt es auch keine Rolle, ob die erste multifunktionale Elektrode zumindest abschnittsweise am oder im Anregungsabschnitt angeordnet ist.

Der piezoelektrische Resonator gemäß dieser Ausgestaltung vereint eine zuverlässige Schwingungsanregung und -analyse des Anregungsabschnitts mit einer Vielzahl von zusätzlichen Mess- und Betriebsfunktionen, welche mit der ersten multifunktionalen Elektrode gleichzeitig zur Schwingungsanregung oder -analyse ausgeführt werden können.

In einer weiteren exemplarischen Ausgestaltung des ersten Aspekts der Erfindung umfasst die Elektrodenstruktur neben der ersten multifunktionalen Elektrode auch eine erste einzelfunktionale Elektrode mit einem ersten Einzelkontakt. Dabei ist sowohl die erste einzelfunktionale Elektrode als auch die erste multifunktionale Elektrode jeweils zumindest abschnittsweise am oder im Anregungsabschnitt angeordnet. Die Formulierungen "zumindest abschnittsweise" und "am oder im" drücken hierbei jeweils analog aus, was im Vorangegangenen bereits zu entsprechenden Formulierungen im Kontext der Anordnung der Elektrodenstruktur relativ zum Anregungsabschnitt erläutert wurde.

Dadurch, dass auch in dieser Ausgestaltung zwei Elektroden - nämlich die erste einzelfunktionale Elektrode und die erste multifunktionale Elektrode - vorhanden und zumindest abschnittsweise am oder im Anregungsabschnitt angeordnet sind, kann der Anregungsabschnitt des piezoelektrischen Substrats schon dadurch zu mechanischen Schwingungen angeregt werden, dass jeweils an den ersten Einzelkontakt der ersten einzelfunktionalen Elektrode sowie an den ersten Hauptkontakt und/oder den erste Nebenkontakt der ersten multifunktionale Elektrode ein Anregungssignal angelegt wird. Falls es die Geometrie des Substrats, gegebenenfalls in Verbindung mit Materialeigenschaften des gewählten piezoelektrischen Materials des Substrats, oder eine Anforderung an die Art oder Qualität der Schwingungen erfordert, ist es in dieser Ausgestaltung jedoch nicht ausgeschlossen, dass die Elektrodenstruktur auch noch weitere einzelfunktionale Elektroden oder weitere multifunktionale Elektroden umfasst, welche ebenfalls an der Schwingungsanregung mitwirken können.

Der ersten multifunktionale Elektrode kommen in dieser Ausgestaltung somit zwei Funktionen zu, welche verschiedenen Betriebs- oder Verwendungsweisen des piezoelektrischen Resonators zugeordnet werden können:
In einer ersten Verwendungsweise, welche im Folgenden auch als dynamische Verwendung oder als dynamischer Betrieb bezeichnet werden kann, wirkt die erste multifunktionale Elektrode direkt an der Anregung von Schwingungen im Bereich des Anregungsabschnitts mit. Zu diesem Zweck kann ein Anregungssignal an die erste multifunktionale Elektrode über den ersten Hauptkontakt angelegt werden, wobei an den ersten Nebenkontakt entweder gleichzeitig dasselbe Anregungssignal angelegt wird oder der erste Nebenkontakt gleichzeitig vom Anregungssignal elektrisch isoliert wird.

In einer zweiten Verwendungsweise, welche im Folgenden auch als statische Verwendung oder als statischer Betrieb bezeichnet werden kann, können eine Vielzahl von zusätzlichen Messaufgaben oder Betriebsfunktionen mit der multifunktionalen Elektrode ausgeführt werden. Dazu wird diese über den ersten Hauptkontakt und den ersten Nebenkontakt kontaktiert und es wird beispielsweise eine Spannungsmessung, eine Widerstandsmessung und/oder eine Kapazitätsmessung an der ersten multifunktionalen Elektrode zwischen dem ersten Hauptkontakt und dem ersten Nebenkontakt ausgeführt. Ebenso kann die multifunktionale Elektrode elektrisch angesteuert werden, beispielsweise indem ein Heizstrom oder ein Prüfstrom über den ersten Hauptkontakt und den ersten Nebenkontakt durch die erste multifunktionale Elektrode geleitet wird.

Der piezoelektrische Resonator gemäß dieser Ausgestaltung vereint eine zuverlässige Schwingungsanregung und -analyse des Anregungsabschnitts mit einer Vielzahl von zusätzlichen Mess- und Betriebsfunktionen, welche mit der ersten multifunktionalen Elektrode ausgeführt werden können. Im Unterschied zu der zuvor genannten exemplarischen Ausgestaltung können die Schwingungsanregung und - analyse zwar nicht parallel, also gleichzeitig, mit den zusätzlichen Mess- und/oder Betriebsfunktionen ausgeführt werden. Dafür kann die insgesamt notwendige Anzahl an herkömmlichen beziehungsweise einzelfunktionalen Elektroden, welche zumindest abschnittsweise am oder im Anregungsabschnitt angeordnet werden müssen, reduziert werden. Dadurch wird ein höherer Grad an Miniaturisierung und Integration bei nahezu gleicher Multifunktionalität erzielbar.

In einer weiteren exemplarischen Ausgestaltung des ersten Aspekts der Erfindung umfasst die Elektrodenstruktur neben der ersten multifunktionalen Elektrode auch noch eine zweite multifunktionale Elektrode mit einem zweiten Hauptkontakt und einem zweiten Nebenkontakt. Dabei ist sowohl die erste multifunktionale Elektrode als auch die zweite multifunktionale Elektrode jeweils zumindest abschnittsweise am oder im Anregungsabschnitt angeordnet. Die Formulierungen "zumindest abschnittsweise" und "am oder im" drücken hierbei jeweils analog aus, was im Vorangegangenen bereits zu entsprechenden Formulierungen im Kontext der Anordnung der Elektrodenstruktur relativ zum Anregungsabschnitt erläutert wurde. Was im Vorangegangenen im Hinblick auf Funktion, Ausgestaltung, Verschaltung, mögliche Vorteile, Verwendungsmöglichkeiten, sowie im Hinblick auf Abgrenzungen zu herkömmlichen (einzelfunktionalen) Elektroden im Kontext der ersten multifunktionalen Elektrode, des ersten Hauptkontakts und/oder des ersten Nebenkontakts erläutert wurde, gilt analog auch für die zweite multifunktionale Elektrode, den zweiten Hauptkontakt und den zweiten Nebenkontakt.

Dadurch, dass auch in dieser Ausgestaltung zwei multifunktionale Elektroden - nämlich die erste multifunktionale Elektrode und die zweite multifunktionale Elektrode - vorhanden und zumindest abschnittsweise am oder im Anregungsabschnitt angeordnet sind, kann der Anregungsabschnitt des piezoelektrischen Substrats schon dadurch zu mechanischen Schwingungen angeregt werden, dass jeweils an den ersten Hauptkontakt und/oder den erste Nebenkontakt der ersten multifunktionale Elektrode sowie an den zweiten Hauptkontakt und/oder den zweiten Nebenkontakt der zweiten multifunktionale Elektrode ein Anregungssignal angelegt wird. Falls es die Geometrie des Substrats, gegebenenfalls in Verbindung mit Materialeigenschaften des gewählten piezoelektrischen Materials des Substrats, oder eine Anforderung an die Art oder Qualität der Schwingungen erfordert, ist es in dieser Ausgestaltung jedoch nicht ausgeschlossen, dass die Elektrodenstruktur zusätzlich auch noch weitere einzelfunktionale Elektroden oder weitere multifunktionale Elektroden umfasst, welche ebenfalls an der Schwingungsanregung mitwirken können.

Sowohl der ersten multifunktionale Elektrode als auch der zweiten multifunktionalen Elektrode kommen in dieser Ausgestaltung somit zwei Funktionen zu, welche zwei verschiedenen Betriebs- oder Verwendungsweisen des piezoelektrischen Resonators zugeordnet werden können, nämlich einer dynamischen Verwendung und einer statischen Verwendung.

Hierbei gilt für die erste multifunktionale Elektrode und die zweite multifunktionale Elektrode geleichermaßen analog, was im Kontext der vorangegangenen exemplarischen Ausgestaltung im Hinblick auf die dynamische Verwendung respektive statische Verwendung erläutert wurde.

Wie schon die vorangehend genannte exemplarische Ausgestaltung, vereint der piezoelektrische Resonator auch gemäß dieser Ausgestaltung eine zuverlässige Schwingungsanregung und -analyse des Anregungsabschnitts mit einer Vielzahl von zusätzlichen Mess- und Betriebsfunktionen, welche mit der ersten multifunktionalen Elektrode und der zweiten multifunktionalen Elektrode ausgeführt werden können. Insbesondere können in dieser Ausgestaltung mit der ersten multifunktionalen Elektrode und der zweiten multifunktionalen Elektrode gleichzeitig unterschiedliche Mess- und Betriebsfunktionen ausgeführt werden, wodurch der piezoelektrische Resonator noch vielseitiger verwendet werden kann. Ebenso kann die insgesamt notwendige Anzahl an herkömmlichen beziehungsweise einzelfunktionalen Elektroden, welche zumindest abschnittsweise am oder im Anregungsabschnitt angeordnet werden müssen, noch weiter reduziert werden. Dadurch wird ein höherer Grad an Miniaturisierung und Integration bei zugleich hoher Multifunktionalität erzielbar.

In einer weiteren exemplarischen Ausgestaltung des ersten Aspekts der Erfindung umfasst die Elektrodenstruktur neben der ersten multifunktionalen Elektrode und der zweiten multifunktionalen Elektrode aus dem vorangegangenen Beispiel auch noch eine dritte multifunktionale Elektrode mit einem dritten Hauptkontakt und einem dritten Nebenkontakt und eine vierte multifunktionale Elektrode mit einem vierten Hauptkontakt und einem vierten Nebenkontakt. Dabei sind die erste multifunktionale Elektrode, die zweite multifunktionale Elektrode, die dritte multifunktionale Elektrode und die vierte Elektrode jeweils zumindest abschnittsweise am oder im Anregungsabschnitt angeordnet. Die Formulierungen "zumindest abschnittsweise" und "am oder im" drücken hierbei jeweils analog aus, was im Vorangegangenen bereits zu entsprechenden Formulierungen im Kontext der Anordnung der Elektrodenstruktur relativ zum Anregungsabschnitt erläutert wurde. Was im Vorangegangenen im Hinblick auf Funktion, Ausgestaltung, Verschaltung, mögliche Vorteile, Verwendungsmöglichkeiten, sowie im Hinblick auf Abgrenzungen zu herkömmlichen (einzelfunktionalen) Elektroden im Kontext der ersten multifunktionalen Elektrode, des ersten Hauptkontakts und/oder des ersten Nebenkontakts erläutert wurde, gilt analog auch für die zweite, dritte und vierte multifunktionale Elektrode, den zweiten, dritten und vierten Hauptkontakt und den zweiten, dritten und vierten Nebenkontakt.

Wenn hierin und im Folgenden bestimmte Elemente, Baugruppen oder funktionale Einheiten jeweils als "dritte" und/oder "vierte" bezeichnet werden, erfolgt dies lediglich zu dem Zweck einer eindeutigen Benennung. Das heißt, diese Bezeichnungen sind in keiner Weise einschränkend zu verstehen. Ebenso impliziert keine dieser Bezeichnungen das Vorhandensein oder Nicht-Vorhandensein weiterer Elemente, Baugruppen oder funktionalen Einheiten der gleichen Art. So wird durch die Benennung "dritte funktionale Elektrode" weder impliziert noch ausgeschlossen, dass auch weitere multifunktionale Elektroden vorhanden sein müssen oder können. Gleichzeitig ist dadurch, dass die dritte multifunktionale Elektrode den "dritten Hauptkontakt" und den "dritten Nebenkontakt" umfasst, weder impliziert noch ausgeschlossen, dass sie auch noch weitere Kontakte aufweist. Die Bezeichnung "dritter Haupt-/Nebenkontakt" dient hier vielmehr einer eindeutigen Zuordnung dieser Kontakte zur "dritten" multifunktionalen Elektrode.

Das piezoelektrische Substrat kann hierbei beispielsweise eine Stimmgabelform aufweisen und der Anregungsabschnitt einen ersten Zinken und einen zweiten Zinken umfassen. Dabei kann die erste multifunktionale Elektrode und die zweite multifunktionale Elektrode zumindest abschnittsweise im oder am ersten Zinken angeordnet sein, während die dritte multifunktionale Elektrode und die vierte multifunktionale Elektrode zumindest abschnittsweise im oder am zweiten Zinken angeordnet sein können. Durch eine entsprechende Ausgestaltung kann der piezoelektrische Resonator präzise zu Schwingungen angeregt werden, während ein hoher Grad an Miniaturisierung, Integration und Multifunktionalität erzielt wird. Weiterhin kann die Anzahl an herkömmlichen beziehungsweise einzelfunktionalen Elektroden, welche zumindest abschnittsweise am oder im Anregungsabschnitt angeordnet werden müssen, stark reduziert werden.

Ebenso können zumindest die erste und zweite multifunktionale Elektrode, beispielsweise aber auch die dritte und vierte multifunktionale Elektrode, jeweils an oder in unterschiedlichen Oberflächen des piezoelektrischen Substrats angeordnet sein. Beispielsweise können die erste multifunktionale Elektrode und/oder die dritte multifunktionale Elektrode an oder in einer ersten Oberfläche des Substrats angeordnet sein, während die zweite multifunktionale Elektrode und/oder die vierte multifunktionale Elektrode an oder in einer zweiten Oberfläche des Substrats angeordnet sein können. Dabei liegen sich die erste Oberfläche und die zweite Oberfläche gegenüber. Beispielsweise ist durch die erste Oberfläche eine Vorderseite und durch die zweite Oberfläche eine Rückseite des piezoelektrischen Resonators ausgebildet.

Die Formulierungen "zumindest abschnittsweise" und "an oder in" drücken hierbei jeweils analog aus, was im Vorangegangenen bereits zur entsprechenden Formulierung "zumindest abschnittsweise" beziehungsweise "am oder im" im Kontext der Anordnung der Elektrodenstruktur relativ zum Anregungsabschnitt erläutert wurde. Durch eine solche Ausgestaltung können die jeweiligen multifunktionalen Elektroden besonders großflächig ausgebildet werden, sodass sie effektiv für eine Anregung und/oder Analyse von Schwingungen des Anregungsabschnitts verwendet werden können. Weiterhin kann durch die großflächige Ausgestaltung der Elektroden eine verbesserte Sensitivität und Messgenauigkeit bei der Ausführung von zusätzlichen Mess- oder Betriebsfunktionen erzielt werden (etwa im zuvor genannten statischen Betrieb). Außerdem kann eine Herstellung des piezoelektrischen Resonators erleichtert werden.

Die in den vorangegangenen exemplarischen Ausgestaltungen jeweils vorhandenen multifunktionalen Elektroden, also die erste multifunktionale Elektrode, die zweite multifunktionale Elektrode, die dritte multifunktionale Elektrode und/oder die vierte multifunktionale Elektrode (im Folgenden zusammengefasst als "die multifunktionalen Elektroden"), können jeweils mindestens eine der folgenden Ausgestaltungen aufweisen.

Unabhängig von der Anzahl der multifunktionalen Elektroden an dem piezoelektrischen Resonator, kann jede multifunktionale Elektrode eine Widerstandsbahn oder einen Kondensator umfassen. So können verschiedenste Kombinationen von Widerstandsbahnen und Kondensatoren auf bzw. an dem piezoelektrischen Resonator denkbar sein, beispielsweise zwei oder mehr Kondensatoren, zwei oder mehr Widerstandsbahnen, oder jeweils mindestens eine Widerstandsbahn und mindestens ein Kondensator. Weitere Ausführungsformen und Beispiele hierzu finden sich in den nachfolgenden Ausführungen.

Zum Beispiel kann zumindest eine der multifunktionalen Elektroden eine Widerstandsbahn aufweisen, welche sich von einem ersten Ende zu einem zweiten Ende der Widerstandsbahn erstreckt. Dabei ist das erste Ende mit einem jeweiligen Hauptkontakt der jeweiligen multifunktionalen Elektrode elektrisch leitend verbunden und das zweite Ende mit einem jeweiligen Nebenkontakt der jeweiligen multifunktionalen Elektrode elektrisch leitend verbunden, sodass zwischen dem jeweiligen Hauptkontakt und Nebenkontakt eine Widerstandsmessung an der Widerstandsbahn durchgeführt oder Strom durch die Widerstandsbahn geleitet werden kann.

Das Material, aus dem die Widerstandsbahn hergestellt ist, kann dabei einen temperaturabhängigen Widerstand aufweisen, sodass durch eine Widerstandsmessung zwischen einem jeweiligen Hauptkontakt und einem jeweiligen Nebenkontakt der jeweiligen multifunktionalen Elektrode eine Temperaturmessung ermöglicht wird.

Ebenso kann das Material, aus dem die Widerstandsbahn hergestellt ist, auch einen Widerstand aufweisen, der von einer Konzentration eines Zielmediums in einer Umgebung der Widerstandsbahn abhängig ist. Mit "in einer Umgebung" der Widerstandbahn ist dabei gemeint, dass das Zielmedium - insbesondere gelöst in einem Hauptmedium - zumindest den Anregungsabschnitt des piezoelektrischen Resonators umgibt, insbesondere in unmittelbarem Kontakt mit ihm steht. Das Zielmedium kann beispielsweise Wasser sein, während das Hauptmedium ein Öl ist. Durch eine derartige Ausgestaltung kann mittels einer Widerstandsmessung zwischen einem jeweiligen Hauptkontakt und einem jeweiligen Nebenkontakt der jeweiligen multifunktionalen Elektrode eine Konzentrationsmessung durchgeführt werden, beispielsweise eine Feuchtemessung. Beispielsweise kann ein zu hoher Wasseranteil in Motor-, oder Hydrauliköl zu einem erhöhten Verschleiß führen. Durch eine regelmäßige Feuchtemessung kann ein Grenzbereich rechtzeitig ermittle und entsprechende Maßnahmen eingeleitet werden.

Alternativ oder zusätzlich kann die Widerstandsbahn als Heizwiderstand ausgebildet sein. Das bedeutet, dass sie dazu ausgelegt ist, auf eine definierte Heiztemperatur erhitzt zu werden, wenn durch sie ein Heizstrom über ihren jeweiligen Hauptkontakt und ihren jeweiligen Nebenkontakt geleitet wird. Die Heiztemperatur kann dabei insbesondere in Abhängigkeit von einer vorliegenden Umgebungs- oder Medientemperatur festgelegt sein (etwa 10 Kelvin höher als die Medientemperatur) oder auf einen absoluten Wert festgelegt sein (beispielsweise knapp unter 100° Celsius). Dadurch können vielfältige Mess- und Betriebsfunktionen erzielt werden, die im Folgenden anhand von Beispielen noch erläutert werden.

Unabhängig davon, aus welchem Material die Widerstandsbahn hergestellt wird und unabhängig davon, ob sie als Heizwiderstand ausgebildet ist oder nicht, kann die Widerstandsbahn eine Mäanderform aufweisen. Dadurch kann bei gleichem Flächenbedarf eine deutliche Steigerung einer Länge der Widerstandsbahn zwischen dem ersten Ende und dem zweiten Ende der Widerstandsbahn erzielt werden.

Weiterhin kann vorgesehen sein, dass die Widerstandsbahn mindestens 50 Prozent, vorzugsweise sogar mindestens 75 Prozent, einer Oberfläche des Anregungsbereichs oder - falls das piezoelektrische Substrat eine Stimmgabelform aufweist - einer Oberfläche eines Zinkens des Substrats bedecken, wodurch die jeweilige multifunktionale Elektrode besonders effektiv zur Anregung und/oder Analyse von Schwingungen des Anregungsabschnitts verwendet werden kann und eine verbesserte Sensitivität und Messgenauigkeit bei der Ausführung von zusätzlichen Mess- oder Betriebsfunktionen erzielt werden kann.

Weiterhin kann zumindest eine der multifunktionalen Elektroden beispielsweise einen Kondensator umfassen.

Der Kondensator weist dabei eine erste Kondensatorelektrode, welche mit dem jeweiligen Hauptkontakt elektrisch verbunden ist, und eine zweite Kondensatorelektrode, welche mit dem jeweiligen Nebenkontakt elektrisch verbunden ist, auf.

Der Kondensator kann dabei beispielsweise als ein Interdigitalkondensator ausgebildet sein und auf oder in einer Oberfläche des Anregungsabschnitts ausgebildet und mit einer Isolationsschicht oder Passivierungsschicht überzogen sein. Alternativ kann der Kondensator auch in der Art eines Parallelplattenkondensators ausgebildet sein, wobei die erste Kondensatorelektrode durch das piezoelektrische Substrat oder eine Teilschicht des piezoelektrischen Substrats von der zweiten Kondensatorelektrode isoliert ist, wobei beide Kondensatorelektroden durch Teilschichten des Substrats oder durch Isolationsschichten von der Umgebung des piezoelektrischen Resonators elektrisch isoliert sind. Somit kann durch eine Kapazitätsmessung zwischen einem jeweiligen Hauptkontakt und einem jeweiligen Nebenkontakt der jeweiligen multifunktionalen Elektrode eine Dielektrizitätsmessung an einem den piezoelektrischen Resonator umgebenden Medium vorgenommen werden.

Ebenso kann der Kondensator in der Art eines Parallelplattenkondensators ausgebildet sein, wobei die erste Kondensatorelektrode durch eine dielektrische Zwischenschicht von der zweiten Kondensatorelektrode isoliert ist. Dabei kann das Material, aus dem die dielektrische Zwischenschicht gebildet ist, derart gewählt sein, dass eine Dielektrizitätskonstante der dielektrischen Zwischenschicht von einer Konzentration eines Zielmediums in der Umgebung des Kondensators abhängt. Mit "in einer Umgebung" des Kondensators ist dabei gemeint, dass das Zielmedium - insbesondere gelöst in einem Hauptmedium - zumindest den Anregungsabschnitt des piezoelektrischen Resonators umgibt, insbesondere in unmittelbarem Kontakt mit ihm steht. Das Zielmedium kann beispielsweise Wasser sein, während das Hauptmedium ein Öl ist.

Durch eine derartige Ausgestaltung kann mittels einer Kapazitätsmessung zwischen einem jeweiligen Hauptkontakt und einem jeweiligen Nebenkontakt der jeweiligen multifunktionalen Elektrode eine Konzentrationsmessung durchgeführt werden, beispielsweise eine Feuchtemessung. Dabei kann vorgesehen sein, dass die erste Kondensatorelektrode als flächige Elektrode auf oder in einer Oberfläche des Anregungsabschnitts angeordnet ist, die zumindest abschnittsweise durch die Zwischenschicht überdeckt wird, während die zweite Kondensatorelektrode über die Zwischenschicht, der Umgebung des piezoelektrischen Resonators zugewandt, angeordnet ist. Dabei kann die zweite Kondensatorelektrode insbesondere eine Kammstruktur, insbesondere eine Kammstruktur mit seitlichen Zähnen zwischen den Kammzinken, oder eine Rasterstruktur oder eine Perforation aufweisen, sodass die Zwischenschicht durch die zweite Kondensatorelektrode nicht vollständig verdeckt wird und das Zielmedium effektiv mit dem Zwischenabschnitt wechselwirken kann.

Aufgrund der flächigen Ausgestaltung der ersten Kondensatorelektrode - also als geschlossene Fläche, welche als eine unterste Schicht des Kondensators auf oder in einer Oberfläche des Substrats angeordnet ist - kann die jeweilige multifunktionale Elektrode besonders wirksam zur Anregung und/oder Analyse von Schwingungen des Anregungsabschnitts verwendet werden und es kann eine verbesserte Sensitivität und Messgenauigkeit bei der Ausführung von zusätzlichen Mess- oder Betriebsfunktionen erzielt werden. Dabei kann insbesondere vorgesehen sein, dass die flächige erste Kondensatorelektrode mindestens 50 Prozent, vorzugsweise sogar mindestens 75 Prozent, einer Oberfläche des Anregungsbereichs oder - falls das piezoelektrische Substrat eine Stimmgabelform aufweist - einer Oberfläche eines Zinkens des Substrats bedecken.

In einer weiteren exemplarischen Ausgestaltung des ersten Aspekts der Erfindung besteht das piezoelektrische Substrat aus einem Quarz, insbesondere aus Alpha-Quarz. Alpha-Quarz weist als Material für das piezoelektrische Substrate eine sehr hohe Frequenzstabilität auf, sodass der daraus hergestellte piezoelektrische Resonator eine sehr hohe Güte aufweisen kann. Dadurch wird eine sehr präzise Bestimmung der Resonanzfrequenz möglich. Weiterhin kann das aus Alpha-Quarz hergestellte Substrat, wenn das Quarz durch anisotrope Ätzverfahren in bestimmten Kristallrichtungen beziehungsweise unter bestimmten Schnittwinkeln gefertigt wird, eine geringe thermische Quersensitivität aufweisen. Zudem sind anisotrope Ätzverfahren Quarz prozesstechnisch sehr gut kontrollierbar, sodass gewünschte Zielformen mit hoher Präzision und Zuverlässigkeit erzeugt werden können.

In einer weiteren exemplarischen Ausgestaltung des ersten Aspekts der Erfindung besteht das piezoelektrische Substrat aus einem piezoelektrischen Einkristall oder umfasst zumindest einen solchen piezoelektrischen Einkristall, wobei insbesondere Lithiumniobat (LiNbO3) anzuführen ist. LiNbO3 weist gegenüber dem zuvor genannten Quarz einen höheren piezoelektrischen Koppelkoeffizienten auf.

In einer weiteren exemplarischen Ausgestaltung des ersten Aspekts der Erfindung ist das piezoelektrische Substrat einstückig, also aus einem Stück, hergestellt. Dadurch kann die Anzahl an Bauteilen und Fügestellen reduziert werden, wodurch einerseits die Herstellkosten gesenkt und andererseits die Schwingungs- und Messeigenschaften, sowie die Stabilität und Widerstandsfähigkeit gegenüber mechanischen, chemischen oder sonstigen Umweltbelastungen des piezoelektrischen Resonators gegenüber Ausgestaltungen, in denen das Substrat aus mehreren miteinander verbundenen Schichten oder Lagen gebildet ist, verbessert werden können.

Gemäß einem zweiten Aspekt der Erfindung umfasst ein Verfahren zur Verwendung eines piezoelektrischen Resonators gemäß dem ersten Aspekt der Erfindung oder gemäß einer der genannten exemplarischen Ausgestaltung davon, die folgenden Schritte, welche in beliebiger Reihenfolge mittelbar oder unmittelbar nacheinander ausgeführt werden:
- Schritt A: Ausführen einer elektrischen Messung an der ersten multifunktionalen Elektrode zwischen dem ersten Hauptkontakt und dem ersten Nebenkontakt oder elektrisches Ansteuern der ersten multifunktionalen Elektrode über den ersten Hauptkontakt und den ersten Nebenkontakt, und
- Schritt B: Anlegen eines Anregungssignals an die erste multifunktionale Elektrode über den ersten Hauptkontakt, wobei an den ersten Nebenkontakt entweder gleichzeitig dasselbe Anregungssignal angelegt wird oder der erste Nebenkontakt gleichzeitig vom Anregungssignal elektrisch isoliert wird.

Schritt A entspricht der im Vorangehenden erläuterten "statischen Verwendungsweise" des piezoelektrischen Resonators, während Schritt B der "dynamischen Verwendungsweise" entspricht. Unabhängig davon, welcher Schritt zuerst ausgeführt wird, kann der piezoelektrische Resonator durch die mittelbare oder unmittelbare Abfolge der Schritte automatisiert, multifunktional und somit vielseitig verwendet werden. Die Abfolge der Schritte kann beispielsweise in einem periodischen Wechsel kontinuierlich ausgeführt werden, sodass beispielsweise eine Mehrzahl von Mess- oder Betriebsaufgaben kontinuierlich ausgeführt werden können. Hierbei bedeutet eine "mittelbare" Abfolge bzw. ein "mittelbar" nacheinander Ausführen, dass zwischen den Schritten (unabhängig davon, welcher zuerst ausgeführt wird) noch zumindest ein anderer, weiterer Schritt ausgeführt wird. Folgen die Schritte hingegen direkt aufeinander, so entspricht dies einer "unmittelbaren" Abfolge, bzw. einem "unmittelbaren" nacheinander Ausführen.

In einer exemplarischen Ausgestaltung des zweiten Aspekts der Erfindung weist die erste multifunktionale Elektrode einen Kondensator auf und die elektrische Messung in Schritt A umfasst eine Kapazitätsmessung und/oder Spannungsmessung.

Wenn der Kondensator dabei als Interdigitalkondensator ausgebildet ist oder wenn der Kondensator eine erste Kondensatorelektrode und eine zweite Kondensatorelektrode aufweist, welche durch das piezoelektrische Substrat oder eine Teilschicht des piezoelektrischen Substrats von der ersten Kondensatorelektrode isoliert ist, kann - wie im vorangegangenen im Hinblick auf den ersten Aspekt der Erfindung erläutert - wirksam eine Dielektrizitätsmessung an einem den piezoelektrischen Resonator umgebenden Medium ausgeführt werden.

Wenn der Kondensator dabei in der Art eines Parallelplattenkondensators ausgebildet sein, wobei eine erste Kondensatorelektrode durch eine dielektrische Zwischenschicht von einer zweiten Kondensatorelektrode isoliert ist und dabei das Material, aus dem die dielektrische Zwischenschicht gebildet ist, derart gewählt ist, dass eine Dielektrizitätskonstante der dielektrischen Zwischenschicht von einer Konzentration eines Zielmediums in der Umgebung des Kondensators abhängt, kann somit - wie im vorangegangenen im Hinblick auf den ersten Aspekt der Erfindung erläutert - wirksam eine Konzentrationsmessung in Bezug auf das Zielmedium ausgeführt werden.

In einer weiteren exemplarischen Ausgestaltung des zweiten Aspekts der Erfindung weist die erste multifunktionale Elektrode eine Widerstandsbahn auf und die elektrische Messung in Schritt A umfasst eine Widerstandsmessung.

Wenn die Widerstandsbahn dabei aus einem Material hergestellt ist, welches einen temperaturabhängigen Widerstand aufweist, kann somit wirksam eine Temperaturmessung ausgeführt werden.

Wenn die Widerstandsbahn dabei aus einem Material hergestellt ist, welches einen Widerstand aufweist, welcher von einer Konzentration eines Zielmediums in einer Umgebung der Widerstandsbahn abhängig ist, kann somit - wie im vorangegangenen im Hinblick auf den ersten Aspekt der Erfindung erläutert - wirksam eine Konzentrationsmessung in Bezug auf das Zielmedium ausgeführt werden.

In einer weiteren exemplarischen Ausgestaltung des zweiten Aspekts der Erfindung weist die erste multifunktionale Elektrode einen Heizwiderstand auf, und das elektrische Ansteuern in Schritt A umfasst das Leiten eines Heizstroms durch den Heizwiderstand über den ersten Hauptkontakt und den ersten Nebenkontakt.

In dieser Ausgestaltung, bei welcher die erste multifunktionale Elektrode einen Heizwiderstand aufweist, kann durch die entsprechende Verwendung der piezoelektrische Resonator durch den Heizwiderstand gezielt vorübergehend erhitzt werden. Dadurch kann der piezoelektrische Resonator ausgeheizt und gereinigt werden, wobei sich Verunreinigungen, (insbesondere organische) Ablagerungen und dergleichen wirksam von den Oberflächen des piezoelektrischen Resonators ablösen, wenn dieser erhitzt wird. Gleichzeitig kann durch die Erhitzung bei vielen Medien eine Senkung der Viskosität erzielt werden. Dabei kann insbesondere, wenn anschließend an den Schritt A dann noch im Schritt B der Anregungsabschnitt des piezoelektrischen Resonators zu Schwingungen angeregt wird, das Ablösen von Verunreinigungen und Ablagerungen von dessen Oberflächen noch wirksamer erzielt werden.

Dabei kann die Elektrodenstruktur beispielsweise zugleich eine zweite multifunktionale Elektrode aufweisen, die ebenfalls zumindest abschnittsweise am oder im Anregungsabschnitt angeordnet ist und welche einen zweiten Hauptkontakt und einen zweiten Nebenkontakt aufweist und welche in der Art eines Parallelplattenkondensators ausgebildet ist, wobei eine erste Kondensatorelektrode durch eine dielektrische Zwischenschicht von einer zweiten Kondensatorelektrode isoliert ist und dabei das Material, aus dem die dielektrische Zwischenschicht gebildet ist, derart gewählt ist, dass eine Dielektrizitätskonstante der dielektrischen Zwischenschicht von einer Konzentration eines Zielmediums in der Umgebung des Kondensators abhängt. Die erste multifunktionale Elektrode ist dabei zumindest abschnittsweise auf oder in einer ersten Oberfläche des piezoelektrischen Substrats angeordnet und die zweite multifunktionale Elektrode zumindest abschnittsweise auf oder in einer zweiten Oberfläche des piezoelektrischen Substrats, welche der ersten Oberfläche gegenüber liegt. Durch eine derartige Anordnung kann wirksam erzielt werden, dass die zweite multifunktionale Elektrode - und damit auch die von ihr umfasst dielektrische Zwischenschicht - gezielt erhitzt werden kann, wenn der Heizwiderstand in Schritt A elektrischen angesteuert wird.

Der Heizeffekt kann besonders effektiv erreicht werden, wenn die erste multifunktionale Elektrode und die zweite multifunktionale Elektrode dabei in einer Draufsicht auf eine der Oberflächen zumindest abschnittsweise überlappend angeordnet sind.

Durch das gezielte Erhitzen können Rückstände des Zielmediums, welche sich gegebenenfalls in der dielektrischen Zwischenschicht angesammelt haben, effektiv ausgeheizt werden, sodass eine Messung der Konzentration des Zielmediums anschließend wieder präzise vorgenommen werden kann. Dieses Verfahren erweist sich als besonders nützlich, wenn das Zielmedium Wasser ist, also wenn die zweite multifunktionale Elektrode als Feuchtesensor ausgebildet ist. Durch eine Erhitzung auf eine Heiztemperatur von knapp unter 100° Celsius kann hierbei ein wirksames Ausheizen der dielektrischen Zwischenschicht erzielt werden. Durch das Ausheizen des Wassers können mögliche Störeinflüsse auf die Feuchtemessung minimiert werden, sodass der Feuchtesensor anschließend wieder eine präzise und fehlerreduzierte Ermittlung der Feuchte erlaubt.

**In** einer weiteren exemplarischen Ausgestaltung des zweiten Aspekts der Erfindung weist die erste multifunktionale Elektrode erneut einen Heizwiderstand auf und die Elektrodenstruktur weist zusätzlich eine zweite multifunktionale Elektrode auf, die ebenfalls zumindest abschnittsweise am oder im Anregungsabschnitt angeordnet ist und welche einen zweiten Hauptkontakt und einen zweiten Nebenkontakt aufweist. Dabei weist die zweite multifunktionale Elektrode eine Widerstandsbahn mit einem temperaturabhängigen Widerstand auf und die erste multifunktionale Elektrode und die zweite multifunktionale Elektrode sind gemeinsam auf oder in einer Oberfläche des piezoelektrischen Substrats, jedoch seitlich versetzt angeordnet. Unter dem eben genannten seitlichen Versatz kann insbesondere eine Beabstandung der ersten multifunktionalen Elektrode von der zweiten multifunktionalen Elektrode verstanden werden.

Das elektrische Ansteuern in Schritt A umfasst in dieser Ausgestaltung das Leiten eines Heizstroms durch den Heizwiderstand über den ersten Hauptkontakt und den ersten Nebenkontakt für eine erste Zeitdauer T1, wobei anschließend oder zumindest teilweise gleichzeitig für eine zweite Zeitdauer T2 eine Widerstandsmessung zwischen dem zweiten Hauptkontakt und dem zweiten Nebenkontakt an der Widerstandsbahn der zweiten multifunktionalen Elektrode ausgeführt wird. Aus einer Amplitude und/oder einem zeitlichen Versatz einer messbaren Temperaturerhöhung an der zweiten multifunktionalen Elektrode gegenüber dem Beginn und/oder Ende der Zeitdauer T1 kann auf eine Strömungsgeschwindigkeit eines den piezoelektrischen Resonator umgebenden Mediums in Richtung des seitlichen Versatzes zwischen der ersten multifunktionalen Elektrode und der zweiten multifunktionalen Elektrode geschlossen werden.

Insbesondere kann es dabei vorgesehen sein, dass die erste multifunktionale Elektrode mit dem Heizwiderstand in Strömungsrichtung des umströmenden Mediums vor der zweiten multifunktionalen Elektrode mit der Widerstandsbahn gelagert ist. Das heißt, dass das Medium zunächst an dem Heizwiderstand der ersten multifunktionalen Elektrode erhitzt wird und sich weiter in Strömungsrichtung zur zweiten multifunktionalen Elektrode bewegt. An der zweiten multifunktionalen Elektrode wird die Temperatur des Mediums gemessen, woraus eine Strömungsgeschwindigkeit des Mediums ableitbar ist.

"Zumindest teilweise gleichzeitig" kann hierbei insbesondere bedeuten, dass die zweite Zeitdauer T2 gleichzeitig mit der ersten Zeitdauer T1 beginnt, jedoch nach deren Ende noch andauert, oder um einen festen zeitlichen Versatz gegenüber der ersten Zeitdauer T1 verzögert beginnt.

In exemplarischen Ausgestaltungen, in welchen das piezoelektrische Substrat eine Stimmgabelform mit einem ersten Zinken und einem zweiten Zinken aufweist, kann dieses Verfahren besonders effektiv angewendet werden, wenn beide, also die erste und die zweite multifunktionale Elektrode auf oder in der gleichen Seite des Substrats, jedoch auf unterschiedlichen Zinken angeordnet sind. Durch die Anordnung auf unterschiedlichen Zinken kann der zuvor beschriebene seitliche Versatz, also die Beabstandung der ersten multifunktionalen Elektrode von der zweiten multifunktionalen Elektrode erreicht werden.

Hinsichtlich des seitlichen Versatzes, also der Beabstandung, kann es ebenso denkbar sein, dass dieser seitliche Versatz durch die Dicke des piezoelektrischen Substrats eingerichtet sein kann. Durch Anordnung der beiden multifunktionalen Elektroden auf zwei voneinander verschiedenen, insbesondere einander gegenüberliegende, Oberflächen des piezoelektrischen Substrats kann die zuvor beschriebene Messung einer Strömungsgeschwindigkeit des Mediums durchgeführt werden. Bei zwei gegenüberliegenden Oberflächen kann es sich beispielsweise um die Vorder- und Rückseite des piezoelektrischen Substrats handeln.

Gemäß dem dritten Aspekt der Erfindung umfasst ein Multivariablensensor einen piezoelektrischen Resonator gemäß dem ersten Aspekt der Erfindung oder gemäß einer der genannten exemplarischen Ausgestaltung davon, sowie eine Steuerelektronik und einen ersten Schalter.

Die Steuerelektronik kann beispielsweise in Form einer integrierten Schaltung, insbesondere als Mikrocontroller ausgebildet sein. Dadurch kann ein hoher Funktionsgrad bei gleichzeitig kleiner Bauform, robuster Bauweise und geringem Stromverbrauch erzielt werden.

Der erste Schalter ist dazu eingerichtet, in einer ersten Schalterstellung den ersten Hauptkontakt und den erste Nebenkontakt der ersten multifunktionalen Elektrode getrennt voneinander an die Steuerelektronik elektrisch anzubinden oder bereitzustellen und in einer zweiten Schalterstellung den ersten Nebenkontakt von der Steuerelektronik zu isolieren und/oder den ersten Nebenkontakt mit dem ersten Hauptkontakt kurzzuschließen, während der erste Hauptkontakt weiterhin an die Steuerelektronik elektrisch angebunden oder bereitgestellt wird.

"Elektrisch anbinden oder bereitstellen" bedeutet in diesem Kontext insbesondere, dass ein elektrischer Kontakt zwischen einer elektronischen Schnittstelle der Steuerelektronik und dem ersten Hauptkontakt bzw. dem ersten Nebenkontakt hergestellt wird.

Der erste Schalter kann beispielsweise als eigenständiges Element oder Bauteil vorgesehen sein, welches als elektronisches Verbindungsglied zwischen der Steuerelektronik und der ersten multifunktionalen Elektrode vorgesehen ist. Alternativ können Steuerelektronik und erster Schalter jedoch auch in einer einzigen Einheit kombiniert sein, beispielsweise in einem Mikrocontroller. Der erst Hauptkontakt und der erste Nebenkontakt können in einer derartigen Ausgestaltung permanent mit unterschiedlichen elektronischen Schnittstellen (beispielsweise mit unterschiedlichen Kontaktpins oder Eingängen) des Mikrokontrollers verbunden sein. Die Funktion des Schalters, also die Realisierung der ersten Schalterstellung beziehungsweise der zweiten Schalterstellung, ist dann rein logisch in einer im Mikrocontroller hinterlegten Firmware abgebildet, was im Folgenden auch als Beschaltungslogik bezeichnet wird.

Unabhängig davon, wie der erste Schalter ausgestaltet ist - etwa physisch als eigenes Bauteil oder beispielsweise datentechnisch integriert als Beschaltungslogik in einem Mikrocontroller - wird die Steuerelektronik durch den ersten Schalter in der ersten Schalterstellung dazu in die Lage versetzt, zwischen dem ersten Hauptkontakt und dem ersten Nebenkontakt eine Vielzahl von verschiedenen Messaufgaben oder Betriebsfunktionen auszuführen.

Beispielsweise kann die Steuerelektronik dazu eingerichtet sein, zwischen dem ersten Hauptkontakt und dem ersten Nebenkontakt eine Spannungsmessung und/oder eine Widerstandsmessung und/oder eine Kapazitätsmessung an der ersten multifunktionalen Elektrode auszuführen. Das Ergebnis der Messung kann als ein erstes Messsignal direkt zwecks einer weiteren Verarbeitung in einer externen Einheit bereitgestellt werden oder zunächst durch die Steuerelektronik selbst verarbeitet und als erstes verarbeitetes Messwertsignal bereitgestellt werden. "Messsignal" bedeutet in diesem Kontext ein primäres Messergebnis wie etwa ein an einer Widerstandsbahn gemessener Widerstand, während ein "verarbeitetes Messwertsignal" einer auf Basis des primären Messergebnisses berechneten Zielgröße, wie etwa einer Umgebungstemperatur, entspricht.

Alternativ oder zusätzlich kann die Steuerelektronik dazu eingerichtet sein, zwischen dem ersten Hauptkontakt und dem ersten Nebenkontakt einen Heizstrom oder einen Prüfstrom durch die erste multifunktionale Elektrode zu leiten, falls diese einen Heizwiderstand umfasst.

**In** der zweiten Schalterstellung wird die Steuerelektronik hingegen durch den ersten Schalter dazu in die Lage versetzt, über den ersten Hauptkontakt ein Anregungssignal an der ersten multifunktionalen Elektrode anzulegen, sodass diese an einer Schwingungsanregung des Anregungsabschnitts mitwirkt und anschließend das Anregungssignal abzuschalten und über den ersten Hauptkontakt ein Abklingsignal zu empfangen und dieses als zweites Messsignal oder als zweites verarbeitetes Messwertsignal bereitzustellen. Während dessen wird der erste Nebenkontakt entweder von der Steuerelektronik isoliert (was im Falle einer Realisierung des ersten Schalters als integraler Bestandteil der Steuerelektronik in Form einer Beschaltungslogik in einem Mikrocontroller bedeuten kann, dass an den ersten Nebenkontakt einfach kein Anregungssignal, insbesondere kein Potenzial angelegt wird) oder der ersten Nebenkontakt wird mit dem ersten Hauptkontakt kurzgeschlossen (was im Falle einer Realisierung des ersten Schalters als integraler Bestandteil der Steuerelektronik in Form einer Beschaltungslogik in einem Mikrocontroller bedeuten kann, dass an den ersten Nebenkontakt einfach gleichzeitig das gleiche Anregungssignal angelegt wird). "Messsignal" bedeutet in diesem Kontext ein primäres Messergebnis wie etwa eine aus dem Abklingsignal abgeleitete Schwingungsfrequenz, Schwingungsamplitude oder Schwingungsdämpfung, während ein "verarbeitetes Messwertsignal" einer auf Basis des primären Messergebnisses berechneten Zielgröße wie etwa einer Viskosität oder Dichte entspricht.

In einer exemplarischen Ausgestaltung des dritten Aspekts der Erfindung ist der Multivariablensensor dazu eingerichtet, mit der Steuerelektronik und einem jeweils entsprechend ausgebildeten piezoelektrischen Resonator eines oder mehrere der vorangehend genannten Verfahren gemäß dem zweiten Aspekt der Erfindung auszuführen.

Aus dem Vorangegangenen wird ersichtlich, dass der Multivariablensensor durch den ersten Schalter in der Lage ist, den in den Verfahren gemäß dem zweiten Aspekt der Erfindung erforderlichen Wechsel zwischen den darin genannten Schritten A und B automatisiert auszuführen. Die erste Schalterstellung entspricht nämlich gerade einer Beschaltung der ersten multifunktionalen Elektrode, wie sie im jeweiligen Schritt A der Verfahren - dem "statischen Betrieb" oder der "statischen Verwendungsweise" - erforderlich ist, während die zweite Schalterstellung einer Beschaltung entspricht, wie sie im jeweiligen Schritt B der Verfahren - dem "dynamischen Betrieb" oder der "dynamischen Verwendungsweise" - benötigt wird. Entsprechend können die Verwendungsverfahren ohne Weiteres durch die Steuerelektronik ausgeführt werden, beispielsweise durch Hinterlegung entsprechender Anweisungen in der Firmware einer als Mikrocontroller ausgebildeten Steuerelektronik.

Wenn der piezoelektrische Resonator entsprechend den Anforderungen eines der Verfahren zusätzlich zur ersten multifunktionalen Elektrode noch weitere multifunktionale Elektroden aufweist, etwa eine zweite multifunktionale Elektrode mit einem zweiten Hauptkontakt und einem zweiten Nebenkontakt, so kann der erste Schalter dazu ausgebildet sein, die Kontakte aller vorhandenen multifunktionalen Elektroden gleichzeitig so zu beschalten, wie es im Vorangegangenen im Hinblick auf die Beschaltung des ersten Hauptkontakts und des ersten Nebenkontakts der ersten multifunktionalen Elektrode erläutert wurde. Alternativ kann der Multivariablensensor aber auch für jede vorhandene multifunktionale Elektrode einen eigenen Schalter aufweisen, also etwa einen zweiten Schalter für die zweite multifunktionale Elektrode, einen dritten Schalter für eine dritte multifunktionale Elektrode und/oder einen vierten Schalter für eine vierte multifunktionale Elektrode. Für jeden weiteren Schalter gilt für seine Ausgestaltung und Funktion im Hinblick auf die ihm jeweils zugeordnete multifunktionale Elektrode entsprechend das gleiche analog, was im Vorangegangenen im Hinblick auf den ersten Schalter, dessen Ausgestaltungen und Funktion in Bezug auf die erste multifunktionale Elektrode erläutert wurde.

In dieser Ausgestaltung des Multivariablensensors können somit eine Vielzahl von zusätzlichen Mess- und Betriebsfunktionen umgesetzt werden, sodass er äußerst vielseitig und multifunktional verwendet werden kann.

In einer weiteren exemplarischen Ausgestaltung des dritten Aspekts der Erfindung umfasst der Multivariablensensor ein Gehäuse mit einer Prozessschnittstelle und einer Signalschnittstelle.

Die Prozessschnittstelle ist dazu eingerichtet, an eine Messstelle an einem Behälter oder einer Fluidleitung angeschlossen zu werden, beispielsweise an einen Öltank einer mobilen Arbeitsmaschine. Ferner ist die Prozessschnittstelle durch eine Dichtung abgeschlossen, welche verhindert, dass ein Medium aus dem Behälter oder der Fluidleitung in das Gehäuse des Multivariablensensors eindringt. Der Anregungsabschnitt ragt über die Dichtung hinaus, während der Basisabschnitt zumindest abschnittsweise in einen Gehäuseinnenraum des Gehäuses hineinragt. Dadurch kann der Anregungsabschnitt wirksam mit einem Medium innerhalb des Behälters oder der Fluidleitung wechselwirken, während der Basisabschnitt effektiv vor einem Kontakt mit dem Medium geschützt ist.

Die Dichtung kann beispielsweise als Glasdurchführung ausgebildet sein, wobei das piezoelektrische Substrat in der Glasdurchführung eingeglast ist. Durch eine derartige Ausgestaltung kann eine besonders zuverlässige, langlebige Abdichtung der Prozessschnittstelle erzielt werden, welche insbesondere auch eine hohe Beständigkeit gegenüber chemischen Beeinträchtigungen aufweist. Gleichzeitig sorgt die Glasverbindung zur Dichtung für eine Versteifung des piezoelektrischen Substrats im Übergangsbereich zwischen dem Anregungsabschnitt und dem Basisabschnitt, sodass der Basisabschnitt wirksam von Schwingungen und Vibrationen des Anregungsabschnitts abgeschirmt wird. Wenn im vorliegenden Fall von "Glas" gesprochen wird, so kann hierunter insbesondere ein anorganisches, glasartiges Material verstanden werden, beispielsweise ein oxidisches Glas (etwa Silikatglas, Borosilikatglas, Alumosilikatglas oder ein anderes technisches Glas) und/oder ein glasartiges Lotmaterial, insbesondere ein Glaslot beziehungsweise eine Glasfritte, gegebenenfalls auch ein (teil-)kristallisierendes beziehungsweise devitrifizierendes Glaslot.

Der Offenbarungsgehalt dieser Schrift ist nicht auf die Merkmale der vorangehend genannten exemplarischen Ausführungsformen und/oder Weiterbildungen beschränkt, sondern umfasst auch beliebige Kombinationen dieser Merkmale, insofern sie sich nicht logisch gegenseitig ausschließen.

Im Folgenden werden weitere exemplarische Ausgestaltungen der Erfindung anhand von Figuren erläutert. Dabei zeigen:
- Figur 1A und 1B: schematisch eine exemplarische Ausgestaltung eines piezoelektrischen Resonators in perspektivischen Ansichten, jeweils von einer Vorderseite und einer Rückseite,
- Figur 2A und 2B: schematisch jeweils unterschiedliche Ausgestaltungen des piezoelektrischen Resonators aus Figur 1A in einer Schnittdarstellung,
- Figur 3: schematisch abschnittsweise den piezoelektrischen Resonator aus Figur 1A in einer vergrößerten Ansicht,
- Figur 4A: schematisch eine erste exemplarische Ausgestaltung eines Multivariablensensors in einem Querschnitt,
- Figur 4B: schematisch eine zweite exemplarische Ausgestaltung eines Multivariablensensors in einem Querschnitt, und
- Figur 5: schematisch eine weitere Ausführungsform eines piezoelektrischen Resonators.

Einander entsprechende Teile sind in allen Figuren mit den gleichen Bezugszeichen versehen.

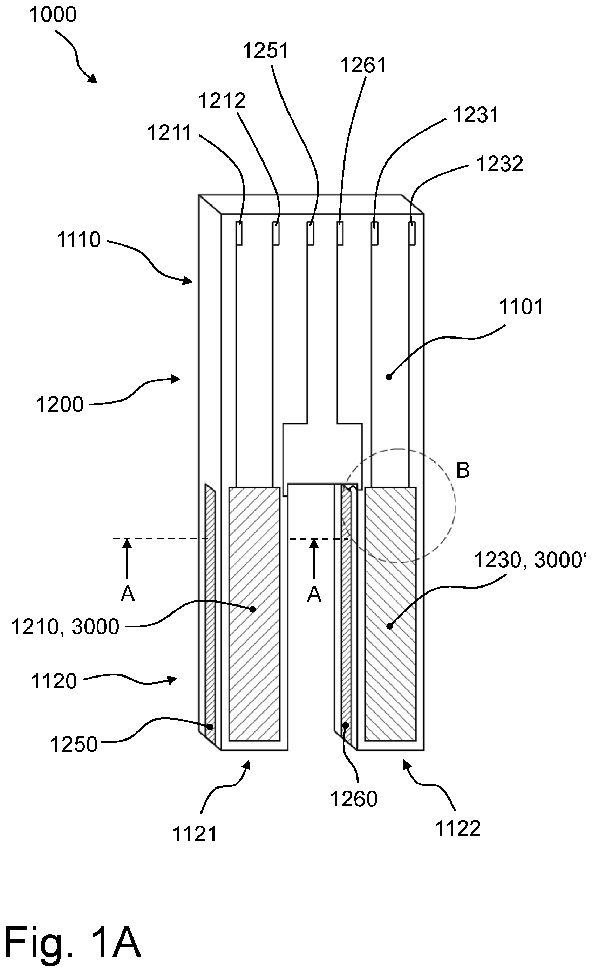

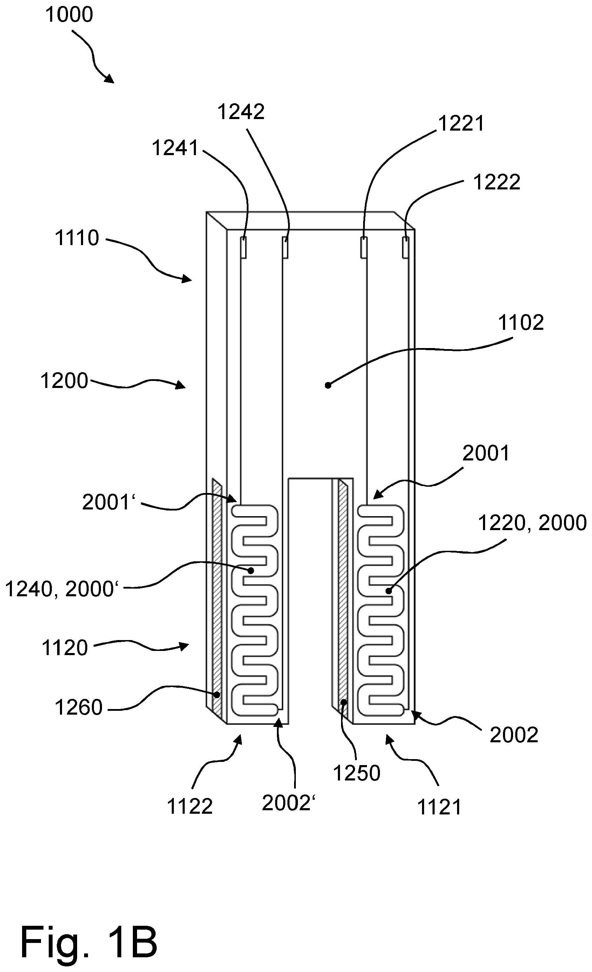

Die Figuren 1A und 1B zeigen eine exemplarische Ausgestaltung eines piezoelektrischen Resonators 1000 gemäß dem ersten Aspekt der Erfindung.

Dieser umfasst ein piezoelektrisches Substrat 1100, welches eine Stimmgabelform mit einem oberen Basisabschnitt 1110 und einem unteren Anregungsabschnitt 1120 mit einem ersten Zinken 1121 und einem zweiten Zinken 1122 aufweist, sowie eine Elektrodenstruktur 1200.

In Figur 1A ist der piezoelektrische Resonator 1000 in einer Vorderseitenansicht bzw. Vorderseite dargestellt, sodass eine erste Oberfläche 1101 des Substrats 1100 sichtbar ist. Die Elektrodenstruktur 1200 umfasst eine erste multifunktionale Elektrode 1210, welche am ersten Zinken 1121 auf beziehungsweise in der ersten Oberfläche 1101 ausgebildet ist.

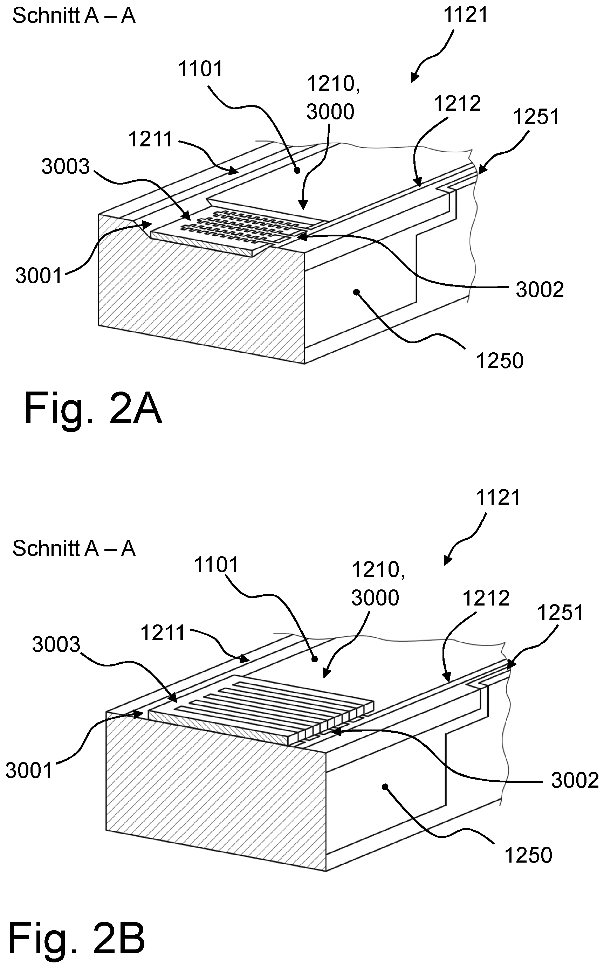

In Figur 2A, welche den in Figur 1A eingezeichneten Schnitt A-A durch den ersten Zinken 1121 vergrößert darstellt, ist zu erkennen, dass die erste multifunktionale Elektrode 1210 hierbei einen Kondensator 3000 umfasst beziehungsweise als solcher ausgebildet ist. Der Kondensator 3000 umfasst eine erste Kondensatorelektrode 3001, welche eine geschlossene Bodenfläche des Kondensators 3000 bildet. Über ihr ist eine dielektrische Zwischenschicht 3003 angeordnet, über welcher wiederum eine zweite Kondensatorelektrode 3002 angeordnet ist. Die erste Kondensatorelektrode 3001 ist elektrisch mit einem ersten Hauptkontakt 1211, die zweite Kondensatorelektrode 3002 mit einem ersten Nebenkontakt 1212 der ersten multifunktionalen Elektrode verbunden. Die dielektrische Zwischenschicht 3003 weist eine Dielektrizitätskonstante auf, welche von einer Konzentration eines Zielmediums in der Umgebung des Kondensators abhängt, beispielsweise von einer Wasserkonzentration, sodass der Kondensator 3000 als Feuchtesensor verwendet werden kann. Da die zweite Kondensatorelektrode 3002 eine Kammstruktur mit seitlichen Zinken aufweist, kann ein den piezoelektrischen Resonator 1000 umgebendes Medium in direkten Kontakt mit der dielektrischen Zwischenschicht 3003 kommen, sodass diese effektiv mit dem Medium wechselwirken kann.

Die Figur 2B zeigt eine alternative Ausführungsform der eben beschrieben Figur 2A. Es ist ebenfalls ein vergrößerter Ausschnitt des ersten Zinkens 1121 dargestellt. Im Gegensatz zu der in Figur 2A gezeigten Ausführungsform ist der Kondensator 3000 bei der in Figur 2B gezeigten alternativen Ausführungsform auf ein weitgehend ebenes Substrat aufgebracht. Die zweite Kondensatorelektrode 3002 wird abschnittsweise von der dielektrischen Zwischenschicht 3003 überdeckt. Im Übrigen kann auf die oben schon zur Figur 2A gemachten Ausführungen verwiesen werden.

Weiterhin umfasst die Elektrodenstruktur 1200 eine dritte multifunktionale Elektrode 1230, welche am zweiten Zinken 1122 auf beziehungsweise in der ersten Oberfläche 1101 ausgebildet ist (vgl. Figur 1A).

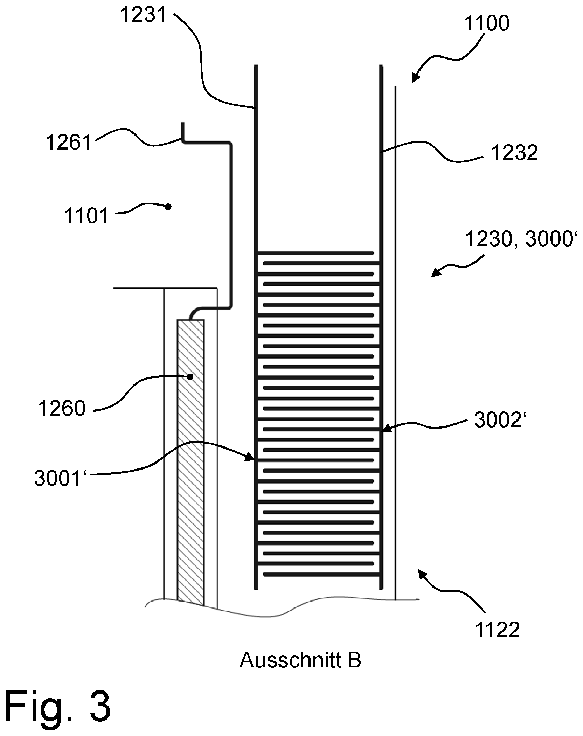

Wie in Figur 3, welche den in Figur 1A mit einem Kreis markierten Bereich B in einer vergrößerten Detailansicht zeigt, zu sehen ist, umfasst die dritte multifunktionale Elektrode 1230 ebenfalls eine Kondensator 3000' oder ist als solcher ausgebildet. Der Kondensator 3000' ist als Interdigitalkondensator ausgebildet, was bedeutet, dass eine erste Kondensatorelektrode 3001' und eine zweite Kondensatorelektrode 3002' des Kondensators 3000' jeweils eine Kammstruktur aufweisen und ineinandergreifend, jedoch elektrisch isoliert voneinander, angeordnet sind. Die erste Kondensatorelektrode 3001' ist dabei mit einem dritten Hauptkontakt 1231 und die zweite Kondensatorelektrode 3002' ist mit einem dritten Nebenkontakt 1232 der dritten multifunktionalen Elektrode 1230 elektrisch verbunden.

In Figur 1B ist der piezoelektrische Resonator 1000 in einer Rückseitenansicht bzw. Rückseite dargestellt, sodass eine zweite Oberfläche 1102 des Substrats 1100 sichtbar ist, welche der ersten Oberfläche 1101 gegenüberliegt. Die Elektrodenstruktur 1200 umfasst eine zweite multifunktionale Elektrode 1220, welche am ersten Zinken 1121 auf beziehungsweise in der zweiten Oberfläche 1102 ausgebildet ist und eine vierte multifunktionale Elektrode 1240, welche am zweiten Zinken 1122 auf beziehungsweise in der zweiten Oberfläche 1102 ausgebildet ist.

Die zweite multifunktionale Elektrode 1220 umfasst eine Widerstandsbahn 2000, welche sich von einem ersten Ende 2001 zu einem zweiten Ende 2002 erstreckt. Das erste Ende 2001 ist mit einem zweiten Hauptkontakt 1221 und das zweite Ende 2002 mit einem zweiten Nebenkontakt 1222 der zweiten multifunktionalen Elektrode 1220 elektrisch verbunden. Zugleich umfasst die vierte multifunktionale Elektrode 1240 ebenfalls eine Widerstandsbahn 2000', welche sich von einem ersten Ende 2001' zu einem zweiten Ende 2002' erstreckt. Das erste Ende 2001' ist mit einem vierten Hauptkontakt 1241 und das zweite Ende 2002' mit einem vierten Nebenkontakt 1242 der vierten multifunktionalen Elektrode 1240 elektrisch verbunden. Die Widerstandsbahn (2000, 200') kann beispielsweise in dem Bereich zwischen dem ersten (2001, 2001') und dem zweiten Ende (2002, 2002') einen spiralförmigen oder mäanderförmigen Verlauf aufweisen.

Weiterhin umfasst die Elektrodenstruktur 1200 noch eine erste einzelfunktionale Elektrode 1250, welche nur über einen ersten Einzelkontakt 1251 kontaktierbar ist, und eine zweite einzelfunktionale Elektrode 1260, welche nur über einen zweiten Einzelkontakt 1261 kontaktierbar ist. Die erste einzelfunktionale Elektrode 1250 und die zweite einzelfunktionale Elektrode 1260 weisen nur einen einzigen Kontakt auf, welcher ausreichend dafür ist, ein Potenzial oder Anregungssignal anzulegen. Um deutlich auszudrücken, dass sie nur einen einzigen Kontakt aufweisen, wird dieser jeweils als "Einzelkontakt" bezeichnet. In Abgrenzung zur ersten multifunktionalen Elektrode 1210 (vgl. Figur 1A) werden diese herkömmlichen Elektroden zudem als "einzelfunktional" bezeichnet, um zu verdeutlichen, dass diese nicht dazu geeignet oder ausgebildet sind, um bestimmte elektronische Mess- und/oder Betriebsfunktionen auszuführen, die über das genannte, einfache Anlegen eines Potenzials oder eines Anregungssignals hinausgehen.

Während die erste einzelfunktionale Elektrode 1250 sich umlaufend über die drei seitlichen Flächen des ersten Zinkens 1121 erstreckt, ist die zweite einzelfunktionale Elektrode entsprechend umlaufend über die drei seitlichen Flächen des zweiten Zinkens 1122 ausgedehnt angeordnet. Dadurch können die einzelfunktionalen Elektroden wirksam an der Anregung von Schwingungen der Zinken 1121, 1122 des Anregungsbereichs 1120 mitwirken. Beispielsweise können sie jeweils als Gegenpotential oder Nullpotential gegenüber einem jeweils gemeinsamen Anregungspotential der ersten und zweiten multifunktionalen Elektrode 1210, 1220, beziehungsweise der dritten und vierten multifunktionalen Elektrode 1230, 1240 dienen.

Die in den Figuren 1A bis 3 dargestellte exemplarische Ausgestaltung des piezoelektrischen Resonators 1000 ist somit dazu geeignet, zur Umsetzung der vorangehend genannten Verfahren gemäß dem zweiten Aspekt der Erfindung verwendet zu werden, sodass sämtliche in dessen Kontext genannten Vorteile erzielbar sind.

Weiterhin kann der piezoelektrische Resonator 1000 als Komponente eines Multivariablensensors 4000 verwendet werden, um die im Kontext des dritten Aspekts der Erfindung genannten Vorteile wirksam zu erzielen.

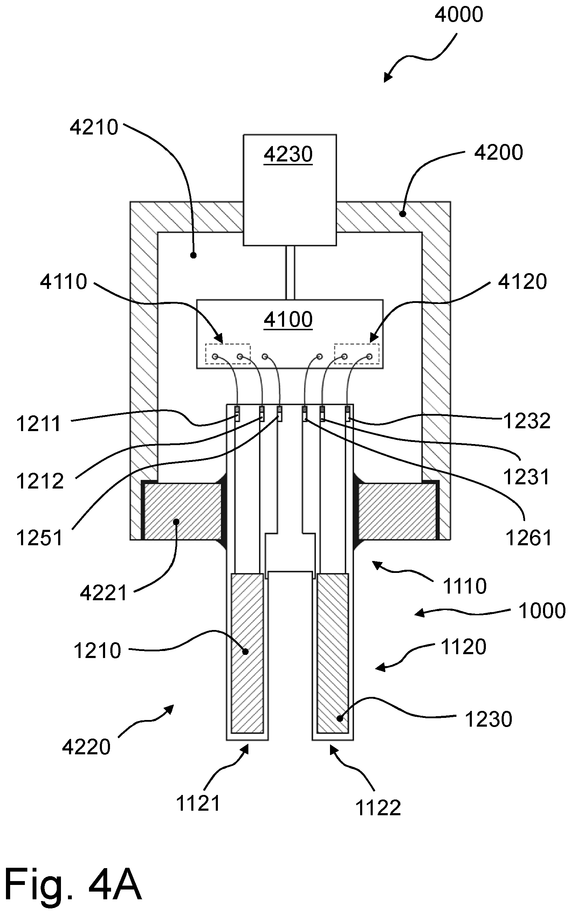

Eine derartige, exemplarische Ausgestaltung gemäß dem dritten Aspekt der Erfindung ist in Figur 4A dargestellt: Eine exemplarische Ausgestaltung eines Multivariablensensors 4000 umfasst einen piezoelektrischen Resonator 1000 mit einem Substrat 1100 und einer Elektrodenstruktur, sowie eine Steuerelektronik 4100 mit einem ersten Schalter 4110 und einem zweiten Schalter 4120, welche jeweils mit einem ersten Hauptkontakt 1211 und einem ersten Nebenkontakt 1212 einer ersten multifunktionalen Elektrode 1210, respektive mit einem zweiten Hauptkontakt 1221 und einem zweiten Nebenkontakt 1222 einer zweiten multifunktionalen Elektrode 1220 der Elektrodenstruktur elektrisch kontaktiert sind. Die Steuerelektronik 4100 ist elektrisch mit der Signalschnittstelle 4230 verbunden, welche zur Kommunikation und zum Datenaustausch mit einem nicht gezeigten Computer, einer Leitwarte oder dergleichen ausgebildet ist. Der piezoelektrische Resonator 1000 kann insbesondere die Merkmale und Ausgestaltungen in den zuvor beschrieben Figuren 1A, bis 3 aufweisen.

Der Multivariablensensor 4000 weist ein Gehäuse 4200 mit einer Prozessschnittstelle 4220 und einem Gehäuseinnenraum 4210 auf, wobei eine Dichtung 4221 vorgesehen ist, welche den Gehäuseinnenraum 4210 versiegelt. Diese Dichtung 4221 ist als Glasformteil ausgebildet, wobei der piezoelektrische Resonator 1000 durch eine Glaslotverbindung in eine Durchführung der Dichtung 4221 derart eingeglast ist, dass ein Anregungsabschnitt 1120 aus der Dichtung herausragt und in Kontakt mit einem Medium treten kann, wenn der Multivariablensensor 4000 mit seiner Prozessschnittstelle 4220 an einen Prozess angeschlossen wird, beispielsweise an einen Öltank.

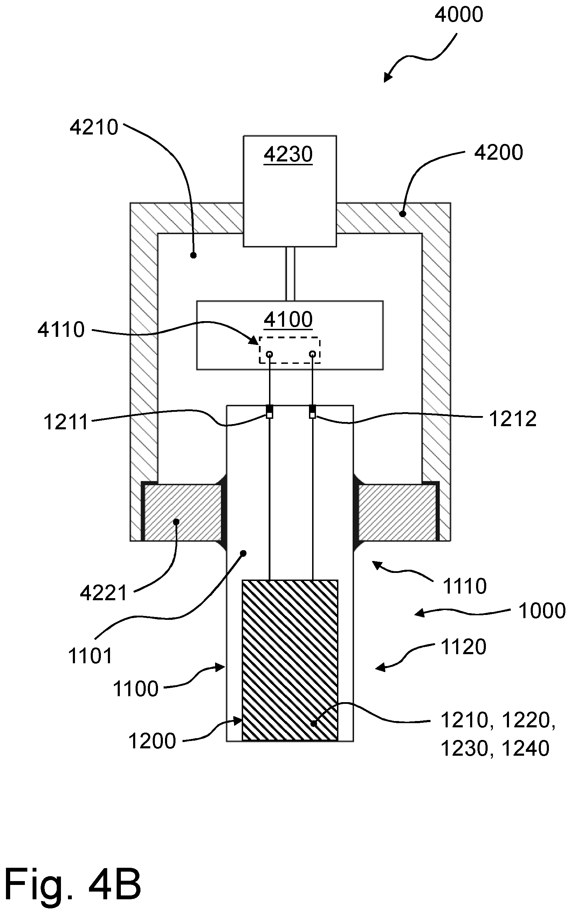

In der Figur 4B ist eine weitere mögliche Ausführungsform des Multivariablensensors 4000 dargestellt. Hinsichtlich einiger Merkmale, wie beispielsweise dem Gehäuse 4200, dem Gehäuseinnenraum 4210 sowie der Abdichtung des Gehäuses 4200 zum piezoelektrischen Resonator 1000 mittels der Dichtung 4221, besteht große Ähnlichkeit zur und teilweise völlige Übereinstimmung mit der Ausführungsform der Figur 4A.

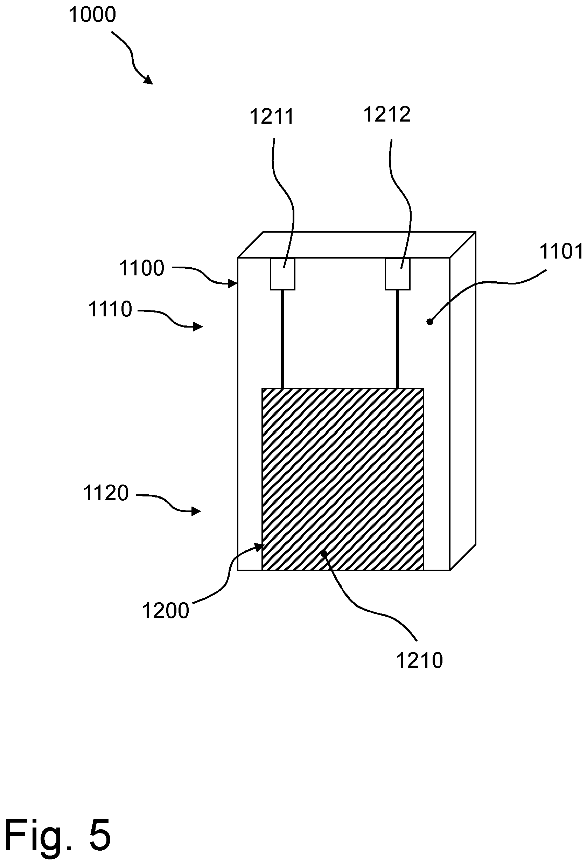

Der piezoelektrische Resonator 1000 hingegen weist keine zwei getrennten Zinken auf, wie dies bei der Ausführungsform gemäß Figur 4A der Fall ist, sondern eine einstückige, geschlossene Form des Substrats 1100; mit anderen Worten: es ist nur ein einziger Zinken abgebildet. Insbesondere kann der einzige Zinken derjenigen Ausführungsform entsprechen, wie sie auch in der Figur 5 gezeigt ist. Dies gilt auch für die Ausführungsform des piezoelektrischen Resonators 1000, die an dieser Stelle vorgesehen sein kann.

Auf dem Substrat 1100 ist die Elektrodenstruktur 1200 angeordnet, welche als erste, zweite, dritte oder vierte multifunktionale Elektrode (1210, 1220, 1230, 1240) ausgestaltet sein kann. Entsprechend kann die multifunktionale Elektrode einen Kondensator oder eine Widerstandsbahn umfassen. Elektrische Leitungen auf und/oder innerhalb des Substrats 1100 stellen Verbindungen zu den beiden Kontakten, nämlich dem ersten Hauptkontakt 1211 und dem ersten Nebenkontakt 1212, her. Ausgehend von dem ersten Hauptkontakt 1211 und dem ersten Nebenkontakt 1212 ist jeweils eine weitere Verbindung zu Steuerelektronik 4100 hergestellt. Ein erster Schalter 4110, wie dies auch in der Figur 4A erkennbar ist, ist als optionales Merkmal anzusehen.

Die Figur 5 zeigt schematisch eine weitere, allgemeine Ausführungsform des piezoelektrischen Resonators 1000. Der piezoelektrische Resonator 1000 umfasst das piezoelektrische Substrat 1100 mit dem Basisabschnitt 1110 und dem Anregungsabschnitt 1120. Das piezoelektrische Substrat 1100 ist im Unterschied zu den Ausführungen der Figuren 1A und 1B als ein einziger "Zinken" ausgebildet.

Weiterhin ist die Elektrodenstruktur 1200 vorgesehen, welche zumindest abschnittsweise am oder im Anregungsabschnitt 1120 angeordnet ist. Die Elektrodenstruktur 1200 umfasst die erste multifunktionale Elektrode 1210, welche den ersten Hauptkontakt 1211 und den ersten Nebenkontakt 1212 aufweist. Die soeben beschriebene Ausführungsform des piezoelektrischen Resonators gemäß Figur 5 kann insbesondere bei dem in Figur 4B beschriebene Multivariablensensor eingesetzt werden.

Im Einklang mit der vorangegangenen Beschreibung der Erfindung sowie im Hinblick auf den Umfang der nachfolgenden Ansprüche sei an dieser Stelle erwähnt, dass eine jeweilige Kennzeichnung beziehungsweise Benennung einzelner multifunktionaler Elektroden in den Figuren 1A, 1B, 2A, 2B, 3, 4A, 4B und 5 als erste multifunktionale Elektrode 1210, als zweite multifunktionale Elektrode 1220, als dritte multifunktionale Elektrode 1230 oder als vierte multifunktionale Elektrode 1240 rein exemplarisch und/oder willkürlich zu verstehen ist/sind. Das bedeutet, dass auch nahezu jegliche andere Nummerierung, Reihenfolge beziehungsweise Bezeichnung denkbar und möglich wäre. Entsprechend sind beispielsweise die in den Figuren 2A und 2B dargestellten exemplarischen Ausgestaltungen einer multifunktionalen Elektrode als Kondensator 3000 / 3000' nicht als darauf eingeschränkt zu verstehen, dass es sich hierbei um eine oder "die" erste multifunktionale Elektrode 1210 handeln muss - eine zweite, dritte oder vierte multifunktionale Elektrode kann ebenso in einer der dargestellten Formen ausgestaltet sein.

Die Erfindung ist nicht auf die vorhergehenden ausführlichen Ausführungsbeispiele beschränkt. Sie kann in dem Umfang der nachfolgenden Ansprüche modifiziert werden. Ebenso können einzelne Merkmale aus den Unteransprüchen miteinander kombiniert werden.

### Bezugszeichenliste

- 1000: Piezoelektrischer Resonator

- 1100: Piezoelektrisches Substrat
- 1110: Basisabschnitt
- 1120: Anregungsabschnitt
- 1121: Erster Zinken
- 1122: Zweiter Zinken
- 1101: Erste Oberfläche
- 1102: Zweite Oberfläche

- 1200: Elektrodenstruktur
- 1210: Erste multifunktionale Elektrode
- 1211: Erster Hauptkontakt
- 1212: Erster Nebenkontakt
- 1220: Zweite multifunktionale Elektrode
- 1221: Zweiter Hauptkontakt
- 1222: Zweiter Nebenkontakt
- 1230: Dritte multifunktionale Elektrode
- 1231: Dritter Hauptkontakt
- 1232: Dritter Nebenkontakt
- 1240: Vierte multifunktionale Elektrode
- 1241: Vierter Hauptkontakt
- 1242: Vierter Nebenkontakt
- 1250: Erste einzelfunktionale Elektrode
- 1251: Erster Einzelkontakt
- 1260: Zweite einzelfunktionale Elektrode
- 1261: Zweiter Einzelkontakt

- 2000, 2000': Widerstandsbahn
- 2001, 2001': Erstes Ende
- 2002, 2002': Zweites Ende
- 3000, 3000': Kondensator
- 3001, 3001': Erste Kondensatorelektrode
- 3002, 3002': Zweite Kondensatorelektrode
- 3003: Dielektrische Zwischenschicht

- 4000: Multivariablensensor
- 4100: Steuerelektronik
- 4110: Erster Schalter
- 4120: Zweiter Schalter
- 4200: Gehäuse
- 4210: Gehäuseinnenraum
- 4220: Prozessschnittstelle
- 4221: Dichtung
- 4230: Signalschnittstelle

## Patentansprüche

1. Piezoelektrischer Resonator (1000) umfassend
- ein piezoelektrisches Substrat (1100) mit einem Basisabschnitt (1110) und einem Anregungsabschnitt (1120) und
- eine Elektrodenstruktur (1200), welche zumindest abschnittsweise am oder im Anregungsabschnitt (1120) angeordnet ist,
**dadurch gekennzeichnet, dass**
die Elektrodenstruktur (1200) eine erste multifunktionale Elektrode (1210) umfasst, welche einen ersten Hauptkontakt (1211) und einen ersten Nebenkontakt (1212) aufweist.

2. Piezoelektrischer Resonator (1000) nach Anspruch 1, wobei die Elektrodenstruktur (1200)
- eine erste einzelfunktionale Elektrode (1250) mit einem ersten Einzelkontakt (1251) und
- eine zweite einzelfunktionale Elektrode (1260) mit einem zweiten Einzelkontakt (1261) umfasst,
wobei die erste einzelfunktionale Elektrode (1250) und die zweite einzelfunktionale Elektrode (1260) jeweils zumindest abschnittsweise am oder im Anregungsabschnitt (1120) angeordnet sind und
die erste multifunktionale Elektrode (1210) am oder im Basisabschnitt (1110) und/oder zumindest abschnittsweise am oder im Anregungsabschnitt (1120) angeordnet ist.

3. Piezoelektrischer Resonator (1000) nach Anspruch 1, wobei die erste multifunktionale Elektrode (1210) zumindest abschnittsweise am oder im Anregungsabschnitt (1120) angeordnet ist und
die Elektrodenstruktur (1200) eine erste einzelfunktionale Elektrode (1250) mit einem ersten Einzelkontakt (1251) umfasst, welche ebenfalls zumindest abschnittsweise am oder im Anregungsabschnitt (1120) angeordnet ist.

4. Piezoelektrischer Resonator (1000) nach Anspruch 1, wobei die erste multifunktionale Elektrode (1210) zumindest abschnittsweise am oder im Anregungsabschnitt (1120) angeordnet ist und
die Elektrodenstruktur (1200) eine zweite multifunktionale Elektrode (1220) umfasst, die ebenfalls zumindest abschnittsweise am oder im Anregungsabschnitt (1120) angeordnet ist und welche einen zweiten Hauptkontakt (1221) und einen zweiten Nebenkontakt (1222) aufweist.

5. Piezoelektrischer Resonator (1000) nach Anspruch 4, wobei die erste multifunktionale Elektrode (1210) zumindest abschnittsweise auf oder in einer ersten Oberfläche (1101) des piezoelektrischen Substrats (1100) angeordnet ist und
die zweite multifunktionale Elektrode (1220) zumindest abschnittsweise auf oder in einer zweiten Oberfläche (1102) des piezoelektrischen Substrats (1100) angeordnet ist, welche der ersten Oberfläche (1101) gegenüber liegt.

6. Piezoelektrischer Resonator (1000) nach Anspruch 4 oder 5, wobei die Elektrodenstruktur (1200)
- eine dritte multifunktionale Elektrode (1230), die ebenfalls zumindest abschnittsweise am oder im Anregungsabschnitt (1120) angeordnet ist und welche einen dritten Hauptkontakt (1231) und einen dritten Nebenkontakt (1232) aufweist, und
- eine vierte multifunktionale Elektrode (1240), die ebenfalls zumindest abschnittsweise am oder im Anregungsabschnitt (1120) angeordnet ist und welche einen vierten Hauptkontakt (1241) und einen vierten Nebenkontakt (1242) aufweist, umfasst.

7. Piezoelektrischer Resonator (1000) nach Anspruch 6, wobei die dritte multifunktionale Elektrode (1230) zumindest abschnittsweise auf oder in einer ersten Oberfläche (1101) des piezoelektrischen Substrats (1100) angeordnet ist und die vierte multifunktionale Elektrode (1240) zumindest abschnittsweise auf oder in einer zweiten Oberfläche (1102) des piezoelektrischen Substrats (1100) angeordnet ist, welche der ersten Oberfläche (1101) gegenüber liegt.

8. Piezoelektrischer Resonator (1000) nach Anspruch 6 oder 7, wobei das piezoelektrische Substrat (1100) eine Stimmgabelform mit mindestens zwei Zinken (1121, 1122) aufweist, wobei der Anregungsabschnitt (1120) einen ersten Zinken (1121) und einen zweiten Zinken (1122) umfasst, und wobei
- die erste multifunktionale Elektrode (1210) und die zweite multifunktionale Elektrode (1220) zumindest abschnittsweise im oder am ersten Zinken (1121) angeordnet sind und
- die dritte multifunktionale Elektrode (1230) und die vierte multifunktionale Elektrode (1240) zumindest abschnittsweise im oder am zweiten Zinken (1122) angeordnet sind.

9. Piezoelektrischer Resonator (1000) nach einem der vorangegangenen Ansprüche, wobei das piezoelektrische Substrat (1100) aus einem piezoelektrischen Einkristall, insbesondere aus einem Quarz oder aus Lithiumniobat besteht oder einen solchen piezoelektrischen Einkristall umfasst, und/oder wobei das piezoelektrische Substrat (1100) einstückig ausgebildet ist.

10. Piezoelektrischer Resonator (1000) nach einem der vorangegangenen Ansprüche, wobei die erste und/oder zweite und/oder dritte und/oder vierte multifunktionale Elektrode (1210, 1220, 1230, 1240)
- eine Widerstandsbahn (2000, 2000') oder
- einen Kondensator (3000, 3000')
umfasst.

11. Piezoelektrischer Resonator (1000) nach Anspruch 10, wobei die Widerstandsbahn (2000, 2000')
- einen temperaturabhängigen Widerstand aufweist und/oder
- einen Widerstand aufweist, der von einer Konzentration eines Zielmediums in einer Umgebung der Widerstandsbahn (2000, 2000') abhängt und/oder
- als Heizwiderstand ausgebildet ist und/oder
- eine Mäanderform aufweist,
und/oder
wobei der Kondensator (3000, 3000')
- als Interdigitalkondensator ausgebildet ist oder
- eine erste Kondensatorelektrode (3001) und eine zweite Kondensatorelektrode (3002) aufweist, welche durch das piezoelektrische Substrat (1100) oder eine Teilschicht des piezoelektrischen Substrats (1100) von der ersten Kondensatorelektrode (3001) isoliert ist, oder
- eine erste Kondensatorelektrode (3001) und eine zweite Kondensatorelektrode (3002) aufweist, welche durch eine dielektrische Zwischenschicht (3003) von der ersten Kondensatorelektrode (3001) isoliert ist, wobei eine Dielektrizitätskonstante der dielektrischen Zwischenschicht (3003) von einer Konzentration eines Zielmediums in der Umgebung des Kondensators (3000, 3000') abhängt.

12. Verfahren zur Verwendung eines piezoelektrischen Resonators (1000) nach einem der vorangegangenen Ansprüche, umfassend folgende Schritte:
- Schritt A: Ausführen einer elektrischen Messung an der ersten multifunktionalen Elektrode (1210) zwischen dem ersten Hauptkontakt (1211) und dem ersten Nebenkontakt (1212) oder
elektrisches Ansteuern der ersten multifunktionalen Elektrode (1210) über den ersten Hauptkontakt (1211) und den ersten Nebenkontakt (1212), und
- Schritt B: Anlegen eines Anregungssignals an die erste multifunktionale Elektrode (1210) über den ersten Hauptkontakt (1211), wobei an den ersten Nebenkontakt (1212) entweder gleichzeitig dasselbe Anregungssignal angelegt wird oder der erste Nebenkontakt (1212) gleichzeitig vom Anregungssignal elektrisch isoliert wird.

13. Verfahren nach Anspruch 12, wobei die erste multifunktionale Elektrode (1210) einen Kondensator (3000, 3000') aufweist und wobei
die elektrische Messung in Schritt A eine Kapazitätsmessung und/oder eine Spannungsmessung umfasst, und/oder wobei die erste multifunktionale Elektrode (1210) eine Widerstandsbahn (2000, 2000') aufweist und wobei die elektrische Messung in Schritt A eine Widerstandsmessung umfasst, und/oder
wobei die erste multifunktionale Elektrode (1210) einen Heizwiderstand aufweist und wobei
das elektrische Ansteuern in Schritt A das Leiten eines Heizstroms durch den Heizwiderstand über den ersten Hauptkontakt (1211) und den ersten Nebenkontakt (1212) umfasst.

14. Verfahren nach Anspruch 12, wobei
- die erste multifunktionale Elektrode (1210) einen Heizwiderstand aufweist und wobei das elektrische Ansteuern in Schritt A das Leiten eines Heizstroms durch den Heizwiderstand über den ersten Hauptkontakt (1211) und den ersten Nebenkontakt (1212) umfasst,
- die Elektrodenstruktur (1200) eine zweite multifunktionale Elektrode (1220) aufweist, die ebenfalls zumindest abschnittsweise am oder im Anregungsabschnitt (1120) angeordnet ist und welche einen zweiten Hauptkontakt (1221) und einen zweiten Nebenkontakt (1222) aufweist und
- die zweite multifunktionale Elektrode (1220) in der Art eines Parallelplattenkondensators ausgebildet ist, wobei eine erste Kondensatorelektrode (3001) durch eine dielektrische Zwischenschicht (3003) von einer zweiten Kondensatorelektrode (3002) isoliert ist und dabei das Material, aus dem die dielektrische Zwischenschicht (3003) gebildet ist, derart gewählt ist, dass eine Dielektrizitätskonstante der dielektrischen Zwischenschicht (3003) von einer Konzentration eines Zielmediums in der Umgebung des Kondensators (3000) abhängt und
- die erste multifunktionale Elektrode (1210) zumindest abschnittsweise auf oder in einer ersten Oberfläche (1101) des piezoelektrischen Substrats (1100) angeordnet ist und die zweite multifunktionale Elektrode (1220) zumindest abschnittsweise auf oder in einer zweiten Oberfläche (1102) des piezoelektrischen Substrats (1100) angeordnet ist, welche der ersten Oberfläche (1101) gegenüber liegt.

15. Verfahren nach Anspruch 12, wobei
- die erste multifunktionale Elektrode (1210) einen Heizwiderstand aufweist und wobei das elektrische Ansteuern in Schritt A das Leiten eines Heizstroms durch den Heizwiderstand über den ersten Hauptkontakt (1211) und den ersten Nebenkontakt (1212) umfasst,
- die Elektrodenstruktur (1200) eine zweite multifunktionale Elektrode (1220) aufweist, die ebenfalls zumindest abschnittsweise am oder im Anregungsabschnitt (1120) angeordnet ist und welche einen zweiten Hauptkontakt (1221) und einen zweiten Nebenkontakt (1222) aufweist und
- die zweite multifunktionale Elektrode (1220) eine Widerstandsbahn (2000) mit einem temperaturabhängigen Widerstand aufweist und
- die erste multifunktionale Elektrode (1210) und die zweite multifunktionale Elektrode (1220) gemeinsam auf oder in einer Oberfläche des piezoelektrischen Substrats (1100), jedoch seitlich versetzt angeordnet sind, und
wobei in Schritt A
- für eine erste Zeitdauer T1 der Heizstroms durch den Heizwiderstand über den ersten Hauptkontakt (1211) und den ersten Nebenkontakt (1212) geleitet wird und anschließend oder zumindest teilweise gleichzeitig
- für eine Zeitdauer T2 eine Widerstandsmessung zwischen dem zweiten Hauptkontakt (1221) und dem zweiten Nebenkontakt (1222) an der Widerstandsbahn (2000) der zweiten multifunktionalen Elektrode (1220) ausgeführt wird.

16. Multivariablensensor (4000) umfassend
- einen piezoelektrischen Resonator (1000) nach einem der Ansprüche 1 bis 11,
- eine Steuerelektronik (4100) und
- einen ersten Schalter (4110),
wobei der erste Schalter (4110) dazu eingerichtet ist,
- in einer ersten Schalterstellung den ersten Hauptkontakt (1211) und den erste Nebenkontakt (1212) getrennt voneinander an die Steuerelektronik (4100) elektrisch anzubinden oder bereitzustellen und
- in einer zweiten Schalterstellung den ersten Nebenkontakt (1212) von der Steuerelektronik (4100) zu isolieren und/oder den ersten Nebenkontakt (1212) mit dem ersten Hauptkontakt (1211) kurzzuschließen, während der erste Hauptkontakt (1211) an die Steuerelektronik (4100) elektrisch angebunden oder bereitgestellt wird.

17. Multivariablensensor (4000) nach Anspruch 16, wobei die Steuerelektronik (4100) dazu eingerichtet ist,
- wenn der erste Schalter (4110) in der ersten Schalterstellung ist, zwischen dem ersten Hauptkontakt (1211) und dem ersten Nebenkontakt (1212) eine elektrische Messung an der ersten multifunktionalen Elektrode (1210) auszuführen und als erstes Messsignal und/oder erstes verarbeitetes Messwertsignal bereitzustellen, und/oder die erste multifunktionale Elektrode (1210) über den ersten Hauptkontakt (1211) und den ersten Nebenkontakt (1212) elektrisch anzusteuern,
sowie
- wenn der erste Schalter (4110) in der zweiten Schalterstellung ist, über den ersten Hauptkontakt (1211) ein Anregungssignal an der ersten multifunktionalen Elektrode (1210) anzulegen, sodass diese an einer Schwingungsanregung des Anregungsabschnitts (1120) mitwirkt und
anschließend das Anregungssignal abzuschalten und über den ersten Hauptkontakt (1211) ein Abklingsignal zu empfangen und dieses als zweites Messsignal und/oder zweites verarbeitetes Messwertsignal bereitzustellen.

18. Multivariablensensor (4000) nach Anspruch 17, wobei
- die erste multifunktionale Elektrode (1210) eine Widerstandsbahn (2000, 2000') umfasst,
wobei, wenn der erste Schalter (4110) in der ersten Schalterstellung ist, die Steuerelektronik (4100) dazu eingerichtet ist,
zwischen dem ersten Hauptkontakt (1211) und dem ersten Nebenkontakt (1212) eine Widerstandsmessung an der Widerstandsbahn (2000, 2000') auszuführen und als erstes Messsignal und/oder erstes verarbeitetes Messwertsignal bereitzustellen, und/oder
zwischen dem ersten Hauptkontakt (1211) und dem ersten Nebenkontakt (1212) einen Heizstrom oder einen Prüfstrom durch die Widerstandsbahn (2000, 2000') zu leiten, und/oder
- die erste multifunktionale Elektrode (1210) einen Kondensator (3000) mit einer ersten Kondensatorelektrode (3001) und einer zweiten Kondensatorelektrode (3002) umfasst,
wobei die erste Kondensatorelektrode (3001) mit dem ersten Hauptkontakt (1211) verbunden ist und die zweite Kondensatorelektrode (3002) mit dem ersten Nebenkontakt (1212) verbunden ist,
wobei, wenn der erste Schalter (4110) in der ersten Schalterstellung ist, die Steuerelektronik (4100) dazu eingerichtet ist, zwischen dem ersten Hauptkontakt (1211) und dem ersten Nebenkontakt (1212) eine Kapazitätsmessung und/oder eine Spannungsmessung am Kondensator (3000) auszuführen und als erstes Messsignal und/oder erstes verarbeitetes Messwertsignal bereitzustellen.

19. Multivariablensensor (4000) nach einem der Ansprüche 16 bis 18, wobei die Steuerelektronik (4100) dazu eingerichtet ist, ein Verfahren nach einem der Ansprüche 12 bis 15 auszuführen.

20. Multivariablensensor (4000) nach einem der Ansprüche 16 bis 19, umfassend ein Gehäuse (4200) mit einer Prozessschnittstelle (4220) und einer Signalschnittstelle (4230), wobei die Prozessschnittstelle (4220) durch eine Dichtung (4221) abgeschlossen ist und
der Anregungsabschnitt (1120) über die Dichtung hinausragt und dabei außerhalb des Gehäuses (4200) angeordnet ist, und
der Basisabschnitt (1110) zumindest abschnittsweise in einen Gehäuseinnenraum (4210) hineinragt, wobei insbesondere die Dichtung (4221) als Glasdurchführung ausgebildet ist und das piezoelektrische Substrat (1100) in der Glasdurchführung eingeglast ist.
